# EUROPEAN PATENT APPLICATION

(11) **EP 3 392 710 A1**
(43) Date of publication of application: **24.10.2018**
(21) Application number: 17756158.6
(22) Date of filing: 03.02.2017
(51) Int. Cl.: G03F 7/039, C08G 63/688, G03F 7/00, G03F 7/004, G03F 7/095, G03F 7/11, G03F 7/32

(54) **POSITIVE PHOTOSENSITIVE RESIN COMPOSITION, POSITIVE LITHOGRAPHIC PRINTING ORIGINAL PLATE AND METHOD FOR PRODUCING LITHOGRAPHIC PRINTING PLATE**

(30) Priority: 25.02.2016 JP 2016034640
(71) Applicant: Fujifilm Corporation, Minato-ku Tokyo 106-8620 (JP)
(72) Inventor: YASUHARA, Yuichi, Haibara-gun Shizuoka 421-0396 (JP); NOZAKI, Atsuyasu, Haibara-gun Shizuoka 421-0396 (JP)
(74) Representative: Hoffmann Eitle
(86) International application number: PCT/JP2017/004121
(87) International publication number: WO 2017/145717

(57) **Abstract**

Provided are: a positive type photosensitive resin composition including a polyester containing a sulfonamide group in a main chain thereof, and an infrared absorbent; a positive type planographic printing plate precursor obtained by using the positive type photosensitive resin composition; and a method of producing a planographic printing plate.

## Description

### BACKGROUND OF THE INVENTION

### 1. Field of the Invention

The present invention relates to a positive type photosensitive resin composition, a positive type planographic printing plate precursor, and a method of producing a planographic printing plate.

### 2. Description of the Related Art

In recent years, lasers have been remarkably developed, and in particular, solid-state lasers and semiconductor lasers having an emission region in a near infrared region to an infrared region, with a high output and a small size, have become easily available. In the field of planographic printing, as an exposure light source at the time of manufacturing a printing plate directly from digital data from a computer or the like, these lasers are very useful.

A positive type planographic printing plate precursor for infrared laser has an alkali-soluble binder resin and an infrared absorbent (IR dye) which absorbs light and generates heat, as essential components. In the unexposed portion (image area), this IR dye and the like act as a development restrainer which substantially decreases the solubility of a binder resin in a developer due to an interaction with the binder resin, and in the exposed portion (non-image area), the interaction between the IR dye and the like and the binder resin weakens due to generated heat, the infrared absorbent and the like dissolve in an alkaline developer, and as a result, a planographic printing plate is formed.

As the planographic printing plate in the related art, the planographic printing plates described in JP1990-156241A (JP-H02-156241A) or JP2005-106910A are known.

### SUMMARY OF THE INVENTION

Since the image forming capability of a positive type planographic printing plate precursor for infrared laser as described above depends on the heat generated by infrared laser exposure to the image recording layer surface, in the vicinity of a support, an image is formed by diffusion of heat to the support, that is, the heat quantity to be used for solubilization of the image recording layer is reduced, and thus, sensitivity becomes low. Therefore, there is a problem in which development restraining ability loss effects of the image recording layer in the non-image area are not sufficiently obtained, the difference between the image area and the non-image area is reduced, and thus, highlight reproducibility is insufficient.

In addition, to solve the above-described problem of the highlight reproducibility, using an image recording layer formed of a material having characteristics in which a non-image area can be more easily developed, that is, the solubility in an alkali aqueous solution is better may be considered, but there is a problem in which such an image recording layer is chemically weakened even in the image area region and easily damaged by an ink washing solvent used in the developer or during printing, or the plate cleaner, that is, is poor in chemical resistance to a plate cleaner or the like used during printing (also simply referred to as "chemical resistance"), and in the unexposed portion region, there is demand for a resin material having characteristics in which the chemical resistance and the durability of the coating film are excellent and the developability thereof becomes excellent after the dissolution suppressing action is removed by exposure.

For the same purpose as described above, various improved techniques have been proposed, and for example, a technique for a planographic printing plate precursor in which an image recording layer containing a polyurethane resin having sulfonamide in the main chain which is insoluble in water and soluble in an alkaline aqueous solution, a photosensitive composition containing a photosensitive compound which acts as a positive type (for example, refer to JP1990-156241A (JP-H02-156241A)) or a water-insoluble and alkali-soluble resin having an active hydrogen in the main chain, on a support, and an infrared absorbent, of which the solubility in an alkaline aqueous solution is increased by exposure is provided has been disclosed (for example, refer to JP2005-106910A). According to these planographic printing plate precursors, it is possible to provide a positive type planographic printing plate precursor having excellent printing durability and excellent chemical resistance.

However, in recent years, diversifying and varying of print materials (paper, ink, and the like) have progressed, and even in the case of using the same printing plate, there is a problem in which the number of printable sheets (hereinafter, referred to as "printing durability") is greatly reduced depending on the type of a print material, in the former technique, chemical resistance is excellent, but there is problem in which, in particular, since the film hardness of the resin used in the underlayer is not sufficient, the printing durability in printing using a low quality print material (paper or ink) is greatly reduced and since the development speed (developability) to an alkali aqueous solution is not sufficient, the difference between the image area and the non-image area is reduced, and thus, highlight reproducibility is not sufficient, and in the latter technique, the printing durability and the highlight reproducibility in printing using a high quality print material (paper or ink) are excellent, but there is problem in which, in particular, since the film hardness of the resin used in the underlayer is not sufficient, the printing durability in printing using a low quality print material (paper or ink) is greatly reduced, and thus, this technique also has room for improvement. Therefore, it is difficult to maintain and improve a plurality of characteristics such as printing durability depending on the film hardness of the underlayer, chemical resistance, the development speed (highlight reproducibility) to an alkali aqueous solution.

An object of an embodiment of the present invention is to provide a positive type photosensitive resin composition which enables production of a positive type planographic printing plate precursor having a non-image area with an excellent solubility in an alkali aqueous solution and enables production of a planographic printing plate having excellent chemical resistance and printing durability; a positive type planographic printing plate precursor obtained by using the positive type photosensitive resin composition; and a method of producing a planographic printing plate.

Specific means for solving the above-described problems includes the following aspects.
<1> A positive type photosensitive resin composition, including:
   a polyester containing a sulfonamide group in a main chain thereof; and
   an infrared absorbent.
<2> The positive type photosensitive resin composition according to <1>, in which the polyester has a constitutional unit represented by the following Formula A-1. 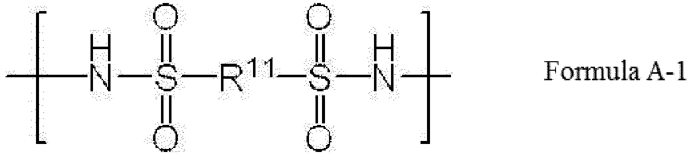
   In Formula A-1, R¹¹ represents a divalent linking group.
<3> The positive type photosensitive resin composition according to <1> or <2>, in which the polyester further has a polycyclic structure in the main chain thereof.
<4> The positive type photosensitive resin composition according to <3>, in which the constitutional unit represented by Formula A-1 includes at least one constitutional unit selected from the group consisting of constitutional units represented by the following Formulae B-1 to B-6. 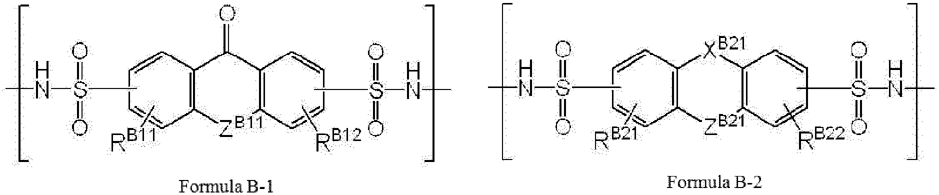 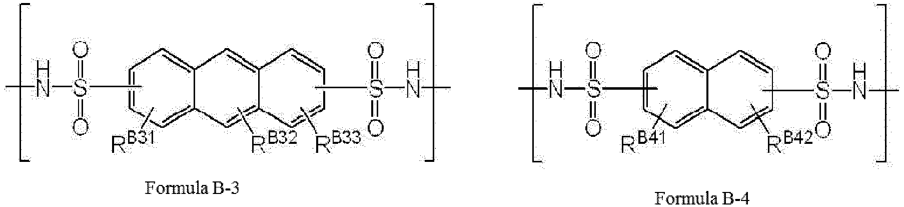 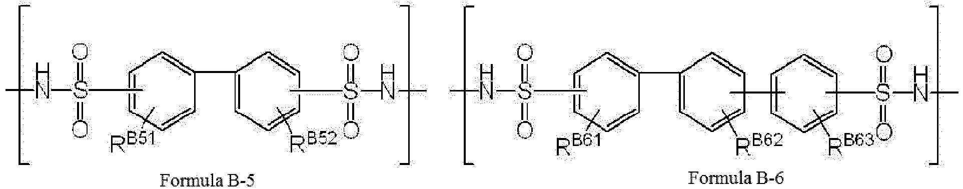
   In Formulae B-1 to B-6, R^{B11}, R^{B12}, R^{B21}, R^{B22}, R^{B31} to R^{B33}, R^{B41}, R^{B42}, R^{B51}, R^{B52}, and R^{B61} to R^{B63} each independently represent a hydrogen atom, a sulfonamide group, a hydroxyl group, a carboxyl group, an alkyl group, or a halogen atom;
   Z^{B11} represents -C(R)₂-, -O-, -NR-, -S-, or a single bond, in which R represents a hydrogen atom or an alkyl group;
   Z^{B21} represents -C(R)₂-, -C(=O)-, -O-, -NR-, -S-, or a single bond, in which R represents a hydrogen atom or an alkyl group; and
   X^{B21} represents -C(R')₂-, -O-, -NR'-, -S-, or a single bond, in which R' represents a hydrogen atom or an alkyl group.
<5> The positive type photosensitive resin composition according to <1>, in which the polyester has a constitutional unit represented by the following Formula A-2. 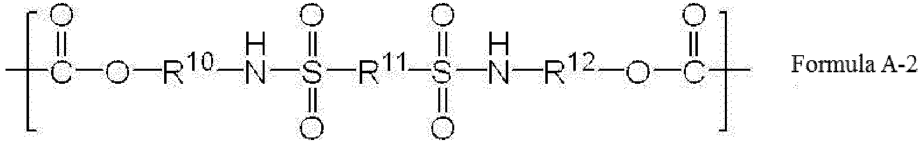
   In Formula A-2, R¹⁰ to R¹² represent a divalent linking group.
<6> The positive type photosensitive resin composition according to <5>, in which the constitutional unit represented by Formula A-2 includes at least one constitutional unit selected from the group consisting of constitutional units represented by the following Formulae C-1 to C-6. 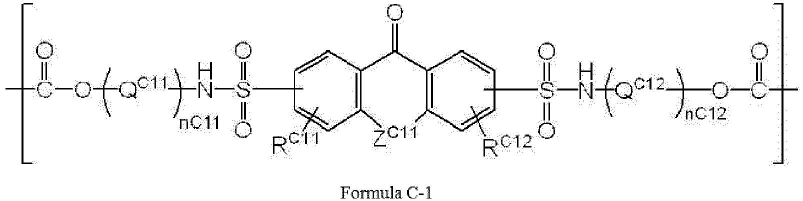 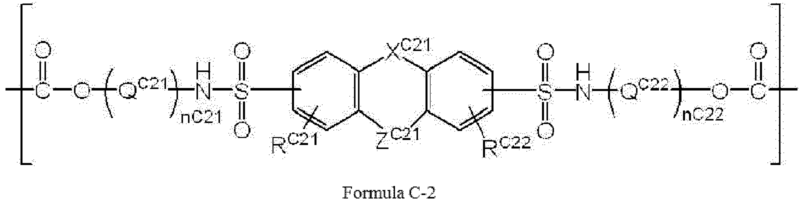 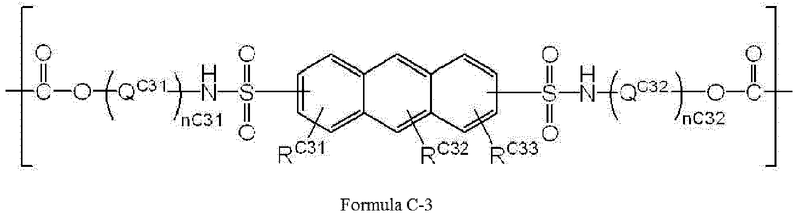 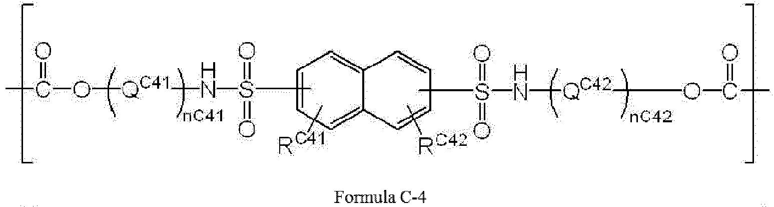 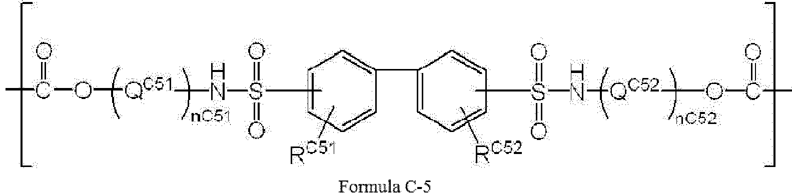 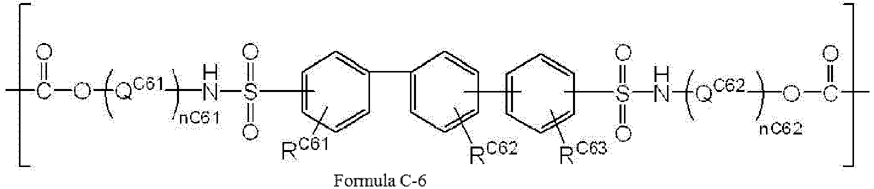
   In Formulae C-1 to C-6, R^{C11}, R^{C12}, R^{C21}, R^{C22}, R^{C31} to R^{C33}, R^{C41}, R^{C42}, R^{C51}, R^{C52}, and R^{C61} to R^{C63} each independently represent a hydrogen atom, a sulfonamide group, a hydroxyl group, a carboxyl group, an alkyl group, or a halogen atom;
   Z^{C11} and Z^{C21} each independently represent -C(R)₂-, -O-, -NR-, -S-, or a single bond, in which R represents a hydrogen atom or an alkyl group;
   X^{C21} represents -C(R')₂-, -O-, -NR'-, -S-, or a single bond, in which R' represents a hydrogen atom or an alkyl group;
   Q^{C11}, Q^{C12}, Q^{C21}, Q^{C22}, Q^{C31}, Q^{C32}, Q^{C41}, Q^{C42}, Q^{C51}, Q^{C52}, Q^{C61}, and Q^{C62} each independently represent an alkylene group, an arylene group, a divalent saturated alicyclic hydrocarbon group, a divalent unsaturated alicyclic hydrocarbon group, or a divalent group formed by a plurality of these groups being linked to one another; and
   nC11, nC12, nC21, nC22, nC31, nC32, nC41, nC42, nC51, nC52, nC61, and nC62 each independently represent an integer of 1 or larger.
<7> The positive type photosensitive resin composition according to <6>, in which the constitutional unit represented by Formula A-2 includes the constitutional unit represented by Formulae C-1 or C-2.
<8> A positive type planographic printing plate precursor, including:
   a support having a hydrophilic surface; and
   an image recording layer containing the positive type photosensitive resin composition according to any one of <1> to <7>, on the support.
<9> The positive type planographic printing plate precursor according to <8>, in which:
   the image recording layer includes an underlayer and an upper layer in this order is formed on the support having the hydrophilic surface; and
   at least one of the underlayer and the upper layer contains the positive type photosensitive resin composition.
<10> The positive type planographic printing plate precursor according to <8> or <9>, further including: an undercoat layer between the support having the hydrophilic surface and the image recording layer.
<11> A method of producing a planographic printing plate, including, in the following order:
   an exposure step of subjecting the positive type planographic printing plate precursor according to any one of <8> to <10> to image-wise light exposure; and
   a development step of subjecting the positive type planographic printing plate precursor after the light exposure to development using an alkali aqueous solution having a pH of from 8.5 to 13.5.

According to an embodiment of the present invention, it is possible to provide a positive type photosensitive resin composition which enables production of a positive type planographic printing plate precursor having a non-image area with an excellent solubility in an alkali aqueous solution and enables production of a planographic printing plate having excellent chemical resistance and printing durability; a positive type planographic printing plate precursor obtained by using the positive type photosensitive resin composition; and a method of producing a planographic printing plate.

### DESCRIPTION OF THE PREFERRED EMBODIMENTS

Hereinafter, the content of the present invention will be described in detail. The description of the constitutive elements as described below is based on representative embodiments of the present invention, but the present invention is not limited to such embodiments. Moreover, in the present specification, "to" is used to show a range in which the numerical values described before and after "to" indicate the upper limit value and the lower limit value.

Regarding the description of a group (atomic group) in the present specification, in a case where the description does not indicate whether a group is substituted or unsubstituted, the description includes both a group having a substituent and a group not having a substituent. For example, "alkyl group" includes not only an alkyl group (an unsubstituted alkyl group) which does not have a substituent, but also an alkyl group (a substituted alkyl group) which has a substituent.

In addition, the chemical structural formulae in the present specification are described using simplified structural formulae in which hydrogen atoms have been omitted, in some cases.

Moreover, in the present specification, "(meth)acrylate" represents acrylate and methacrylate, "(meth)acrylic" represents acrylic and methacrylic, and "(meth)acryloyl" represents acryloyl and methacryloyl.

In addition, in the present specification, "% by mass" has the same meaning as "% by weight" and "part(s) by mass" has the same meaning as "part(s) by weight".

In addition, in the present specification, preferable aspects in a combination are more preferable.

### (Positive type photosensitive resin composition)

A positive type photosensitive resin composition according to the present disclosure includes polyester which contains a sulfonamide group in a main chain; and an infrared absorbent.

In the present disclosure, a "main chain" indicates relatively the longest bonding chain in a molecule of a polymer compound constituting a resin and a "side chain" indicates a carbon chain branched from the main chain.

As a result of extensive examination conducted by the present inventors, it was found that a positive type photosensitive resin composition that contains an infrared absorbent and polyester containing a sulfonamide group in the main chain has an excellent solubility in an alkali aqueous solution of a non-image area in a positive type planographic printing plate precursor to be obtained and excellent chemical resistance and printing durability of a planographic printing plate to be obtained.

Although the action mechanism of the excellent effects due to containing the above materials is not clear, it is estimated as follows.

As the result of examination conducted by the present inventors, it was found that the film hardness of a resin is important for the printing durability in printing and the film hardness is significantly influenced by an interaction between polymer compounds forming an image recording layer. In particular, in low quality print materials, the effect is significant, and in general acrylic resins or polyurethane resins, sufficient film hardness is less likely to be imparted. It is thought that this is because inorganic salt particles (calcium carbonate, kaolin, or the like) included in a print material (paper, ink, or the like) are eluted during printing, this polishes the image area of the printing plate, and as a result, abrasion is promoted.

The polymer compound used for image formation in the present disclosure is polyester that contains a highly interactive sulfonamide group in the main chain, and the interaction between polymer main chains is extremely high. Accordingly, the printing durability and the chemical resistance are assumed to be excellent. Further, it is assumed that the infiltration rate of a developer into the polymer compound is improved and the developability of an exposed portion becomes excellent in a case where the main chain contains a sulfonamide group.

Hereinafter, the polyester containing a sulfonamide group in the main chain, which is an indispensable component of the positive type photosensitive resin composition according to the present disclosure and the infrared absorbent will be described.

### <Polyester containing sulfonamide group in main chain>

The positive type photosensitive resin composition used in the present disclosure contains polyester containing a sulfonamide group in the main chain.

Further, the expression "containing a sulfonamide group in the main chain" means that the main chain contains a divalent group represented by -SO₂-NH-.

### [Polycyclic structure]

It is preferable that the polyester containing a sulfonamide group in the main chain further has a polycyclic structure in the main chain.

The polycyclic structure indicates a fused cyclic hydrocarbon structure, a fused polycyclic aromatic structure, and a structure formed by a plurality of aromatic hydrocarbons being bonded through a single bond. As the polycyclic structure, a naphthalene derivative structure, an anthracene derivative structure, a biphenyl structure, or a terphenyl structure is preferable. Among the naphthalene derivative structure and the anthracene derivative structure, a xanthone structure, an anthrone structure, a xanthene structure, a dihydroanthracene structure, and an anthracene structure are preferable. From the viewpoints of chemical resistance, printing durability, and developability, a xanthone structure, an anthrone structure, a biphenyl structure, and a naphthalene structure are more preferable, and a xanthone structure and an anthrone structure are still more preferable.

### [Molar light absorption coefficient]

In the polyester containing a sulfonamide group in the main chain, the molar light absorption coefficient at the maximum absorption wavelength in a wavelength range of 400 to 700 nm is preferably 100000 or less, more preferably 50000 or less, and still more preferably 20000 or less.

In a case where the molar absorption wavelength is in the above-described range, clear visible image is likely to be obtained in a case where a print-out agent is used.

The maximum absorption wavelength can be measured with a solution obtained by dissolving the polyester containing a sulfonamide group in the main chain in N-methylpyrrolidone using a spectrophotometer.

### [Constitutional unit represented by Formula A-1]

It is preferable that the polyester containing a sulfonamide group in the main chain has a constitutional unit represented by Formula A-1.

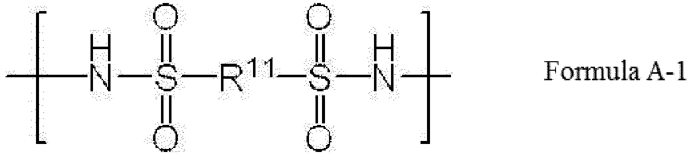

In Formula A-1, R¹¹ represents a divalent linking group.

From the viewpoints of the printing durability and the chemical resistance, R¹¹ represents preferably a divalent linking group having a phenylene group or a polycyclic structure, more preferably a divalent linking group formed of a phenylene group or a polycyclic structure, and still more preferably a divalent linking group formed of a polycyclic structure.

As the polycyclic structure, a naphthalene derivative structure, an anthracene derivative structure, a biphenyl structure, or a terphenyl structure is preferable, and a xanthone structure, an anthrone structure, a xanthene structure, a dihydroanthracene structure, and an anthracene structure, a biphenyl structure, or a terphenyl structure is preferable. From the viewpoints of the chemical resistance, the printing durability, and the developability, a xanthone structure, an anthrone structure, a biphenyl structure, or a naphthalene structure is preferable, and a xanthone structure or an anthrone structure is still more preferable.

The content of the constitutional unit represented by Formula A-1 in the polyester containing a sulfonamide group in the main chain is preferably in a range of 10% to 90% by mass, more preferably in a range of 30% to 80% by mass, and still more preferably in a range of 50% to 70% by mass.

### - Constitutional unit represented by Formulae B-1 to B-6 -

It is preferable that the constitutional unit represented by Formula A-1 includes at least one constitutional unit selected from the group consisting of constitutional units represented by Formulae B-1 to B-6.

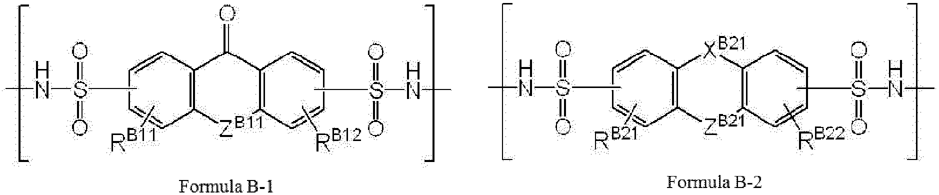

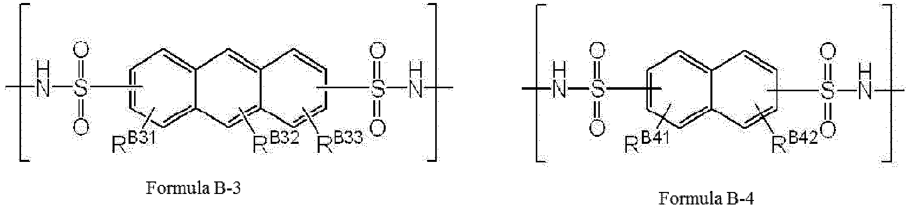

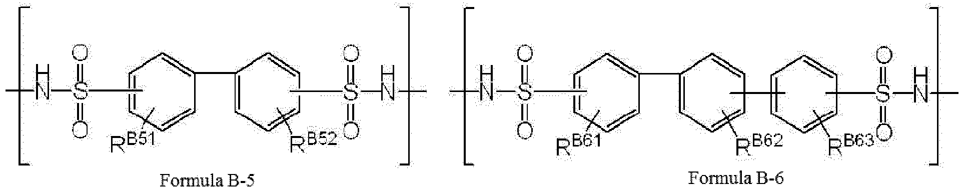

In Formulae B-1 to B-6, R^{B11}, R^{B12}, R^{B21}, R^{B22}, R^{B31} to R^{B33}, R^{B41}, R^{B42}, R^{B51}, R^{B52}, and R^{B61} to R^{B63} each independently represent a hydrogen atom, a sulfonamide group, a hydroxyl group, a carboxyl group, an alkyl group, or a halogen atom, Z^{B11} represents -C(R)₂-, -C(=O)-, -O-, -NR-, -S-, or a single bond, Z^{B21} represent -C(R)₂-, -O-, -NR-, -S-, or a single bond, R represents a hydrogen atom or an alkyl group, X^{B21} represents -C(R')₂-, -O-, -NR'-, -S-, or a single bond, and R' represents a hydrogen atom or an alkyl group.

In Formulae B-1 to B-6, R^{B11}, R^{B12}, R^{B21}, R^{B22}, R^{B31} to R^{B33}, R^{B41}, R^{B42}, R^{B51}, R^{B52}, and R^{B61} to R^{B63} each independently represent a hydrogen atom, a sulfonamide group, a hydroxyl group, a carboxyl group, an alkyl group, or a halogen atom, preferably a hydrogen atom, an alkyl group, or a halogen atom, and more preferably a hydrogen atom. From the viewpoint of improving developability, an acid group such as a sulfonamide group, a hydroxyl group, or a carboxyl group is preferable.

Z^{B11} represents -C(R)₂-, -C(=O)-, -O-, -NR-, -S-, or a single bond, preferably -C(R)₂-, -O-, or a single bond, and more preferably -O- or a single bond.

R represents a hydrogen atom or an alkyl group and preferably a hydrogen atom.

Z^{B21} represents -C(R)₂-, -O-, -NR-, -S-, or a single bond, preferably -C(R)₂- or -O-, and more preferably -O-.

X^{B21} represents -C(R')₂-, -O-, -NR'-, -S-, or a single bond and preferably -C(R')₂-.

R' represents a hydrogen atom or an alkyl group and preferably a hydrogen atom.

The content of at least one constitutional unit selected from the group consisting of constitutional units represented by Formulae B-1 to B-6 in the polyester containing a sulfonamide group in the main chain is preferably in a range of 10% to 90% by mass, more preferably in a range of 30% to 80% by mass, and still more preferably in a range of 50% to 70% by mass.

### [Constitutional unit represented by Formula A-2]

It is preferable that the polyester containing a sulfonamide group in the main chain has a constitutional unit represented by Formula A-2.

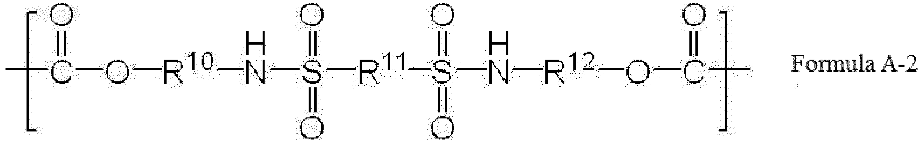

In Formula A-2, R¹⁰ to R¹² represent a divalent linking group.

R¹¹ has the same definition as that for R¹¹ in Formula A-1, and the preferable aspects thereof are the same as described above.

R¹⁰ and R¹² each independently represent preferably an alkylene group, an arylene group, or a divalent saturated alicyclic hydrocarbon group, a divalent unsaturated alicyclic hydrocarbon group, or a divalent group formed by a plurality of these groups being linked to one another, and more preferably an alkylene group or an arylene group.

Further, it is preferable that two ester bonds present at a linking position with other structures in Formula A-2 are bonded to carbon atoms in other structures.

As the alkylene group, an alkylene group having 1 to 20 carbon atoms is preferable, an alkylene group having 2 to 15 carbon atoms is more preferable, and an alkylene group having 2 to 8 carbon atoms is still more preferable. Further, the alkylene group may contain oxygen atoms in the carbon chain. Examples of the substituent which may be included in the alkylene group include an alkyl group, an aryl group, and a halogen atom.

As the arylene group, an arylene group having 6 to 20 carbon atoms is preferable, a phenylene group or a naphthylene group is more preferable, and a phenylene group is still more preferable. The arylene group may contain heteroatoms in the ring structure, and examples of the heteroatoms include an oxygen atom, a nitrogen atom, and a sulfur atom.

As the divalent saturated alicyclic hydrocarbon group, a divalent saturated alicyclic hydrocarbon group having 4 to 10 carbon atoms is preferable, a divalent saturated alicyclic hydrocarbon group having 4 to 8 carbon atoms is more preferable, and a divalent saturated alicyclic hydrocarbon group having 6 to 8 carbon atoms is still more preferable. In addition, examples of the substituent which may be contained in the divalent saturated alicyclic hydrocarbon group include an alkyl group, an aryl group, and a halogen atom.

Examples of the divalent unsaturated alicyclic hydrocarbon group include a cyclopentenyl group, a cyclopentadienyl group, a cyclohexenyl group, a cyclohexadienyl group, and a cycloheptenyl group.

As the divalent group formed by a plurality of these groups being linked to one another, a group formed by a plurality of alkylene groups and arylene groups or a plurality of alkylene groups and divalent saturated alicyclic hydrocarbon groups, being bonded to one another, is preferable or a group formed by bonding an alkylene group, an arylene group, and an alkylene group in this order or bonding an alkylene group, a divalent saturated alicyclic hydrocarbon group, and an alkylene group in this order is preferable.

The content of the constitutional unit represented by Formula A-2 in the polyester containing a sulfonamide group in the main chain is preferably in a range of 10% to 90% by mass, more preferably in a range of 30% to 80% by mass, and still more preferably in a range of 50% to 70% by mass.

### - Constitutional unit represented by Formulae C-1 to C-6 -

It is preferable that the constitutional unit represented by Formula A-2 includes at least one constitutional unit selected from the group consisting of constitutional units represented by Formulae C-1 to C-6.

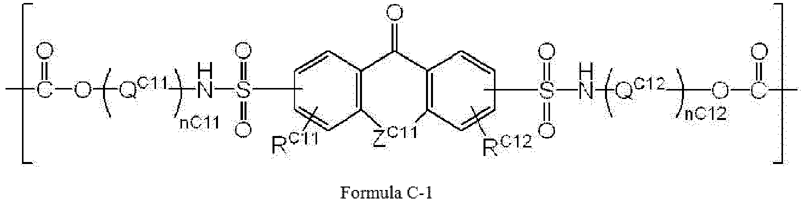

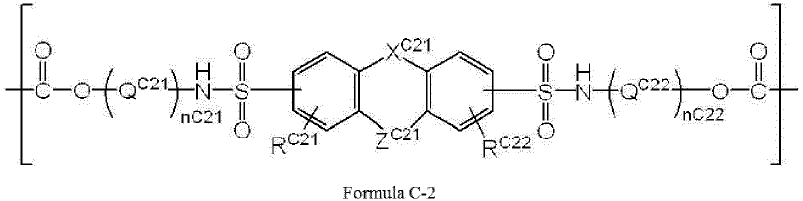

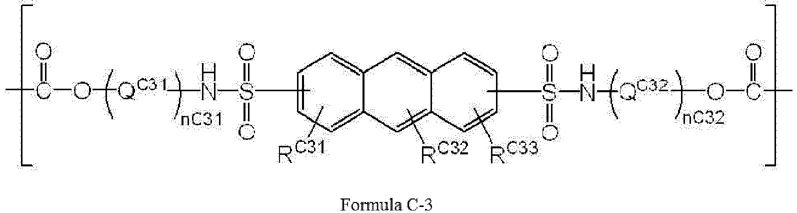

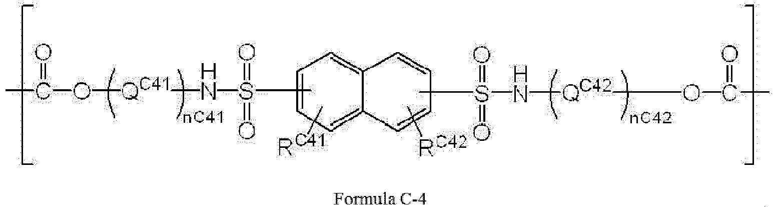

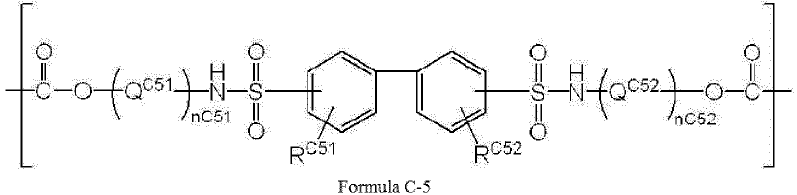

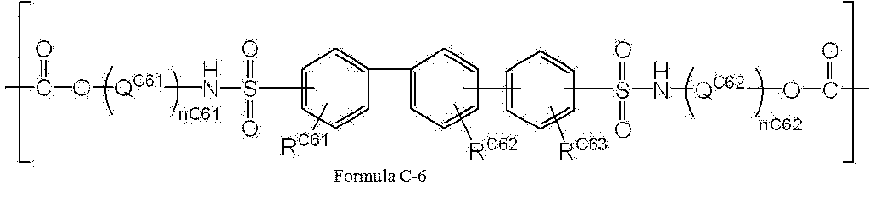

In Formulae C-1 to C-6, R^{C11}, R^{C12}, R^{C21}, R^{C22}, R^{C31} to R^{C33}, R^{C41}, R^{C42}, R^{C51}, R^{C52}, and R^{C61} to R^{C63} each independently represent a hydrogen atom, a sulfonamide group, a hydroxyl group, a carboxyl group, an alkyl group, or a halogen atom, Q^{C11}, Q^{C12}, Q^{C21}, Q^{C22}, Q^{C31}, Q^{C32}, Q^{C41}, Q^{C42}, Q^{C51}, Q^{C52}, Q^{C61}, and Q^{C62} each independently represent an alkylene group, an arylene group, a divalent saturated alicyclic hydrocarbon group, a divalent unsaturated alicyclic hydrocarbon group, or a divalent group formed by a plurality of these groups being linked to one another, and nC11, nC12, nC21, nC22, nC31, nC32, nC41, nC42, nC51, nC52, nC61, and nC62 each independently represent an integer of 1 or greater.

In Formulae C-1 to C-6, R^{C11}, R^{C12}, R^{C21}, R^{C22}, R^{C31} to R^{C33}, R^{C41}, R^{C42}, R^{C51}, R^{C52}, and R^{C61} to RC⁶³ each independently represent preferably a hydrogen atom, an alkyl group, or a halogen atom and more preferably a hydrogen atom. From the viewpoint of improving developability, an acid group such as a sulfonamide group, a hydroxyl group, or a carboxyl group is preferable.

Z^{C11} represents -C(R)₂-, -C(=O)-, -O-, -NR-, -S-, or a single bond, preferably a single bond, -C(R)₂-, or -O-, and more preferably a single bond or -O-.

R represents a hydrogen atom or an alkyl group and preferably a hydrogen atom.

Z^{C21} represents -C(R)₂-, -O-, -NR-, -S-, or a single bond, preferably -C(R)₂- or -O-, and more preferably -O-.

X^{C21} represents -C(R')₂-, -O-, -NR'-, -S-, or a single bond and preferably -C(R')₂-.

R' represents a hydrogen atom or an alkyl group and preferably a hydrogen atom.

It is preferable that Q^{C11}, Q^{C12}, Q^{C21}, Q^{C22}, Q^{C31}, Q^{C32}, Q^{C41}, Q^{C42}, Q^{C51}, Q^{C52}, Q^{C61}, and Q^{C62} each independently represent an alkylene group or an arylene group.

As the alkylene group as Q^{C11}, Q^{C12}, Q^{C21}, Q^{C22}, Q^{C31}, Q^{C32}, Q^{C41}, Q^{C42}, Q^{C51}, Q^{C52}, Q^{C61}, and Q^{C62}, an alkylene group having 1 to 20 carbon atoms is preferable, an alkylene group having 2 to 15 carbon atoms is more preferable, and an alkylene group having 2 to 8 carbon atoms is still more preferable. Further, the alkylene group may contain oxygen atoms in a carbon chain. Examples of the substituent which may be included in the alkylene group include an alkyl group, an aryl group, and a halogen atom.

As the arylene group as Q^{C11}, Q^{C12}, Q^{C21}, Q^{C22}, Q^{C31}, Q^{C32}, Q^{C41}, Q^{C42}, Q^{C51}, Q^{C52}, Q^{C61}, and Q^{C62}, an arylene group having 6 to 20 carbon atoms is preferable, a phenylene group or a naphthylene group is more preferable, and a phenylene group is still more preferable. The arylene group may contain heteroatoms in a ring structure, and examples of the heteroatom include an oxygen atom, a nitrogen atom, and a sulfur atom.

As the divalent saturated alicyclic hydrocarbon group as Q^{C11}, Q^{C12}, Q^{C21}, Q^{C22}, Q^{C31}, Q^{C32}, Q^{C41}, Q^{C42}, Q^{C51}, Q^{C52}, Q^{C61}, and Q^{C62}, a divalent saturated alicyclic hydrocarbon group having 4 to 10 carbon atoms is preferable, a divalent saturated alicyclic hydrocarbon group having 4 to 8 carbon atoms is more preferable, and a divalent saturated alicyclic hydrocarbon group having 6 to 8 carbon atoms is still more preferable. Further, the divalent saturated alicyclic hydrocarbon group may include a substituent. Examples of the substituent include an alkyl group, an aryl group, and a halogen atom.

As the divalent unsaturated alicyclic hydrocarbon group as Q^{C11}, Q^{C12}, Q^{C21}, Q^{C22}, Q^{C31}, Q^{C32}, Q^{C41}, Q^{C42}, Q^{C51}, Q^{C52}, Q^{C61}, and Q^{C62}, a cyclopentenyl group, a cyclopentadienyl group, a cyclohexenyl group, a cyclohexadienyl group, and a cycloheptenyl group are exemplified.

As the divalent group formed by a plurality of these groups being linked to one another as Q^{C11}, Q^{C12}, Q^{C21}, Q^{C22}, Q^{C31}, Q^{C32}, Q^{C41}, Q^{C42}, Q^{C51}, Q^{C52}, Q^{C61}, and Q^{C62}, a group in which a plurality of alkylene groups and arylene groups or a plurality of alkylene groups and divalent saturated alicyclic hydrocarbon groups are bonded is preferable and a group in which an alkylene group, an arylene group, and an alkylene group or an alkylene group, a divalent saturated alicyclic hydrocarbon group, and an alkylene group are bonded in this order is preferable.

nC11, nC12, nC21, nC22, nC31, nC32, nC41, nC42, nC51, nC52, nC61, and nC62 each independently represent an integer of 1 or greater, preferably an integer of 1 to 3, and more preferably 1.

The content of at least one constitutional unit selected from the group consisting of constitutional units represented by Formulae C-1 to C-6 in the polyester containing a sulfonamide group in the main chain is preferably in a range of 10% to 90% by mass, more preferably in a range of 30% to 80% by mass, and still more preferably in a range of 50% to 70% by mass.

### [Alkyleneoxy group]

It is preferable that the polyester containing a sulfonamide group used in the present disclosure in the main chain further includes an alkyleneoxy group in the main chain.

According to the above-described embodiment, it is possible to obtain a positive type photosensitive resin composition which enables production of a positive type planographic printing plate precursor having excellent image formability and enables production of a planographic printing plate precursor having excellent printing durability.

As the alkyleneoxy group, an alkyleneoxy group having 2 to 10 carbon atoms is preferable, an alkyleneoxy group having 2 to 8 carbon atoms is more preferable, an alkyleneoxy group having 2 to 4 carbon atoms is still more preferable, and an ethyleneoxy group or a propyleneoxy group is particularly preferable.

Further, the alkyleneoxy group may be a polyalkyleneoxy group.

As the polyalkyleneoxy group, a polyalkyleneoxy group having 2 to 50 repeating units is preferable, a polyalkyleneoxy group having 2 to 40 repeating units is more preferable, and a polyalkyleneoxy group having 2 to 30 repeating units is still more preferable.

The preferable number of carbon atoms in the repeating units constituting the polyalkyleneoxy group is the same as the preferable number of carbon atoms of the alkyleneoxy group.

It is preferable that the polyester containing a sulfonamide group used in the present disclosure in the main chain is a compound having each constitutional unit represented by Formula D-1.

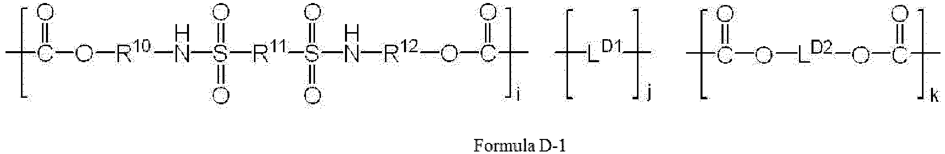

In D-1, R¹⁰ to R¹² each independently have the same definitions as those for R¹⁰ to R¹² in Formula A-2, and the preferable aspects thereof are the same as described above.

L^{D1} represents an alkylene group, an arylene group, or a group formed by a plurality of these groups being bonded to one another and preferably an alkylene group, an arylene group, or a biphenyl structure.

The number of carbon atoms of the alkylene group is preferably in a range of 1 to 20 and more preferably in a range of 1 to 8. Further, the alkylene group may be linear, branched, or cyclic.

As the arylene group, a phenylene group or a naphthylene group is preferable and a phenylene group is more preferable.

As the group formed by a plurality of these groups being bonded to one another, an alkylene-arylene-alkylene group and an arylene-arylene group are exemplified, and a biphenyl structure is more preferable.

L^{D2} represents an alkylene group, an alkyleneoxy group, a polyalkyleneoxy group, an arylene group, -NR-, or a group formed by a plurality of these groups being bonded to one another. Among these, an alkylene group or a polyalkyleneoxy group is preferable.

R represents a hydrogen atom or an alkyl group and preferably an alkyl group having 1 to 10 carbon atoms.

The number of carbon atoms of the alkylene group is preferably in a range of 1 to 20 and more preferably in a range of 1 to 8. Further, the alkylene group may be linear, branched, or cyclic.

The alkyl group may include a substituent, and examples of the substituent include an aryl group, an aralkyl group, and a halogen atom. The substituent may be bonded to an alkyl group through an amide bond or an ester bond. Further, the substituent may further include a substituent. From the viewpoint of the developability, it is preferable that the substituent further includes an acid group as a substituent. Examples of the acid group include a carboxyl group, a phenolic hydroxyl group, and a sulfonamide group. Among these, a sulfonamide group is preferable.

The number of carbon atoms of the alkyleneoxy group is preferably in a range of 2 to 10 and more preferably in a range of 2 to 4. In addition, an ethyleneoxy group or a propyleneoxy group is still more preferable.

As the polyalkyleneoxy group, a polyalkyleneoxy group having 2 to 50 repeating units is preferable, a polyalkyleneoxy group having 2 to 40 repeating units is more preferable, and a polyalkyleneoxy group having 2 to 30 repeating units is still more preferable.

The preferable number of carbon atoms in the repeating units constituting the polyalkyleneoxy group is the same as the preferable number of carbon atoms of the alkyleneoxy group.

As the arylene group, a phenylene group or a naphthylene group is preferable and a phenylene group is more preferable.

As the group formed by a plurality of these groups being bonded to one another, an alkylene-arylene-alkylene group and the like are exemplified.

i, j, and k represent a content ratio (% by mass) in a case where the total mass of molecules of the polyester containing a sulfonamide group in the main chain is set to 100, and i:j:k is preferably in a range of 90:10:0 to 40:50:10 and more preferably in a range of 70:30:0 to 50:40:10. Further, the total value of i and j is preferably 90 or greater and more preferably 95 or greater. The total value of i, j, and k is preferably 95 or greater, more preferably 98 or greater, and still more preferably 99 or greater.

The terminal of the compound having each constitutional unit represented by Formula D-1 is not particularly limited, and is typically a carboxyl group or a hydroxy group and preferably a hydroxy group. Further, the terminal thereof may be blocked by a known terminal blocking agent used for producing polyester.

### [Method of producing polyester containing sulfonamide group in main chain]

The polyester containing a sulfonamide group in the main chain used in the present disclosure can be produced by a sequential polymerization reaction of, for example, a diol compound containing a sulfonamide group, a diol compound which does not contain a sulfonamide group as necessary, and a dicarboxylic acid compound.

Specifically, it is preferable that the polyester is produced by a sequential polymerization reaction of a diol compound represented by Formula E-1 with any or both of a dicarboxylic acid compound represented by Formula E-2A and a bifunctional carboxylic acid halide compound represented by Formula E-2B and then with a diol compound represented by Formula E-3 as necessary.

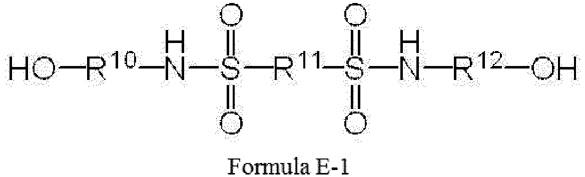

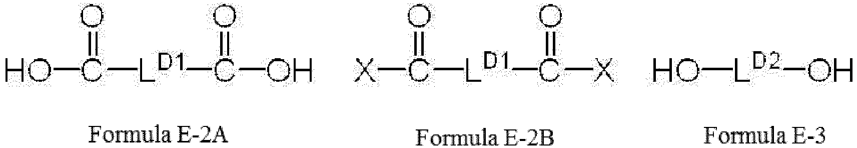

In Formulae E-1, E-2A, E-2B, and E-3, R¹⁰ to R¹² each independently have the same definitions as those for R¹⁰ to R¹² in Formula D-1, and the preferable aspects thereof are the same as described above.

L^{D1}'s each independently have the same definitions as that for L^{D1} in Formula D-1, and the preferable aspects thereof are the same as described above.

L^{D2} has the same definition as that for L^{D2} in Formula D-1, and the preferable aspects thereof are the same as described above.

Hereinafter, specific examples of the diol compound represented by Formula E-1, the dicarboxylic acid compound represented by Formula E-2A, the bifunctional carboxylic acid halide compound represented by Formula E-2B, and the diol compound represented by Formula E-3 will be described. Further, each compound used in the present disclosure is not limited to the following specific examples.

### - Diol compound represented by Formula E-1 -

Specific examples of the diol compound represented by Formula E-1 include compounds represented by Formulae SA-1 to SA-33.

In Formulae SA-1 to SA-33, description on carbon atoms and hydrogen atoms contained in hydrocarbons will not be provided.

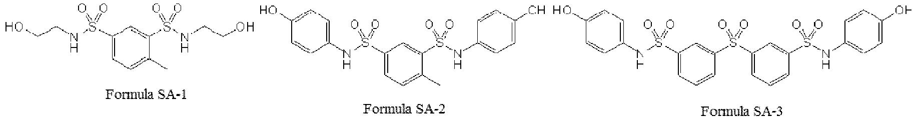

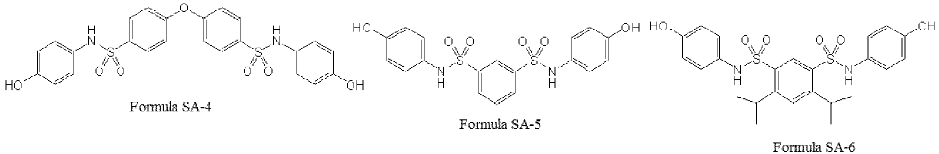

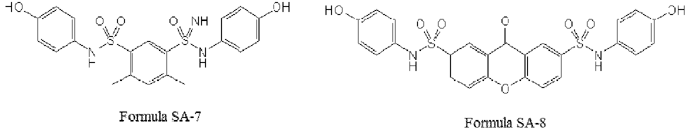

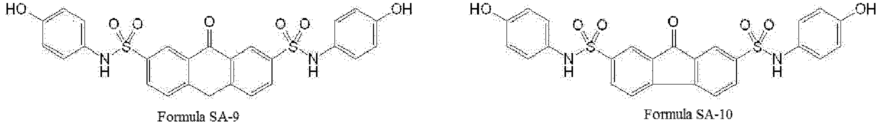

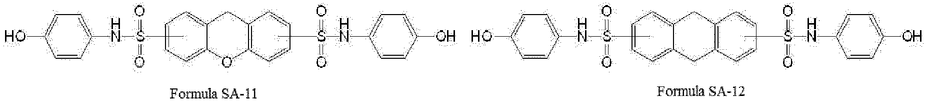

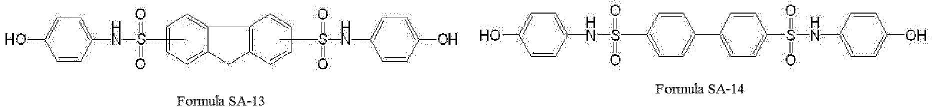

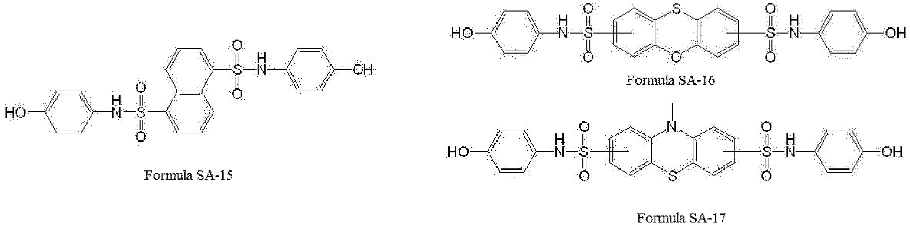

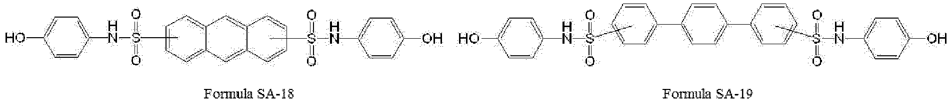

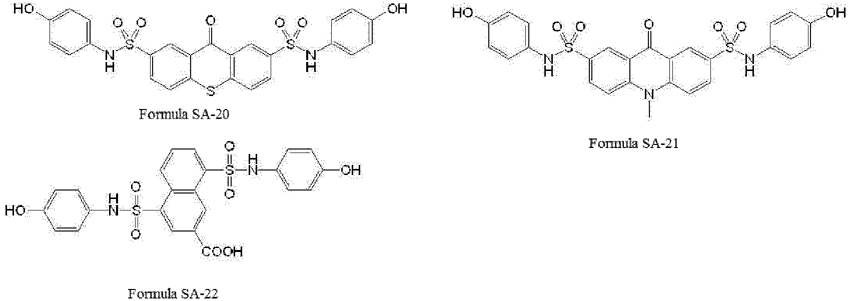

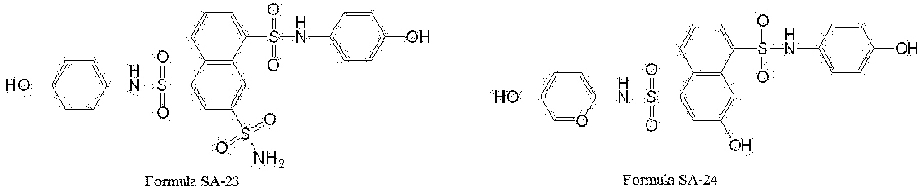

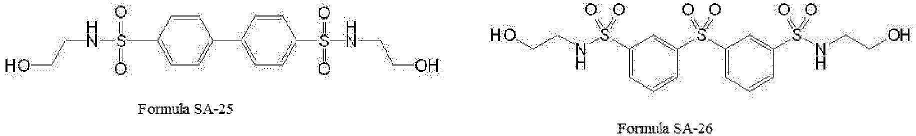

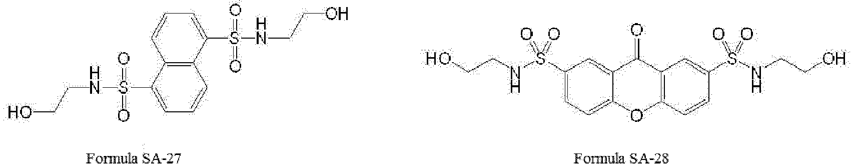

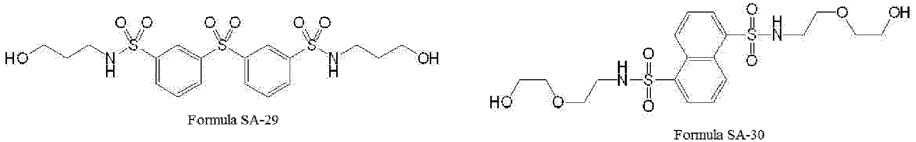

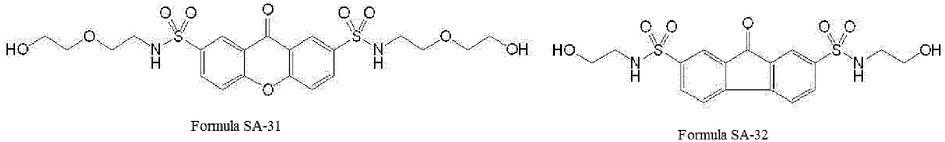

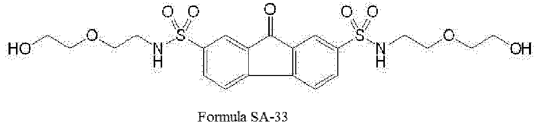

### - Dicarboxylic acid compound represented by Formula E-2A -

Specific examples of the dicarboxylic acid compound represented by Formula E-2A include compounds represented by Formulae CA-1 to CA-12.

In Formulae CA-1 to CA-12, description on carbon atoms and hydrogen atoms contained in hydrocarbons will not be provided.

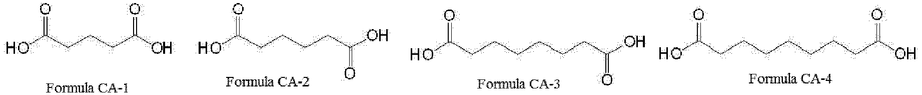

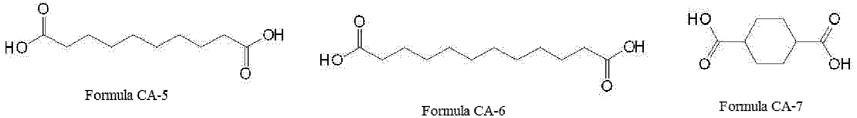

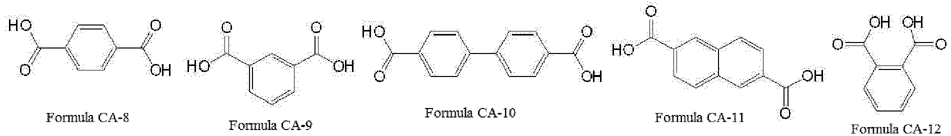

### - Bifunctional carboxylic acid halide compound represented by Formula E-2B -

Specific examples of the bifunctional carboxylic acid halide compound represented by Formula E-2B include compounds represented by Formulae CH-1 to CH-11.

In Formulae CH-1 to CH-11, X represents a halogen atom, and description on carbon atoms and hydrogen atoms contained in hydrocarbons will not be provided. As the halogen atom, a fluorine atom, a chlorine atom, a bromine atom, or an iodine atom is preferable, a fluorine atom or a chlorine atom is more preferable, and a chlorine atom is still more preferable.

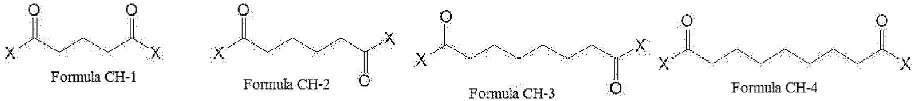

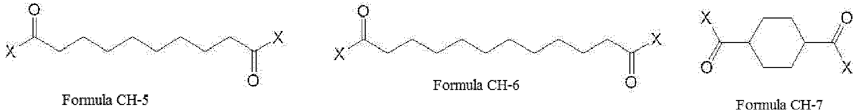

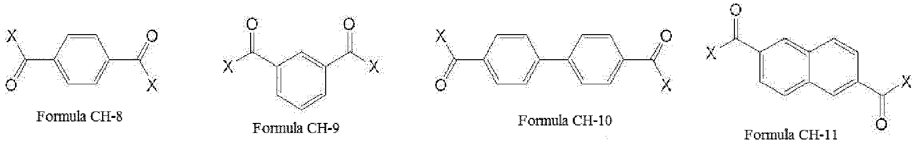

### - Diol compound represented by Formula E-3 -

Specific examples of the diol compound represented by Formula E-3 include compounds represented by Formulae DO-1 to DO-18.

In Formulae DO-1 to DO-18, n represents the number of repeating units in a polyalkyleneoxy group, Mn represents the number average molecular weight, and description on carbon atoms and hydrogen atoms contained in hydrocarbons will not be provided.

In the present disclosure, the number average molecular weight can be calculated by a standard polystyrene conversion method using gel permeation chromatography (GPC). A column filled with a polystyrene crosslinked gel (TSKgel SuperAWM-H; manufactured by Tosoh Corporation) can be used as the GPC column, and N-methylpyrrolidone (0.01 mol/L of each of phosphoric acid and lithium bromide) can be used as the GPC solvent.

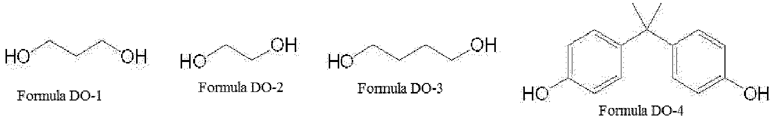

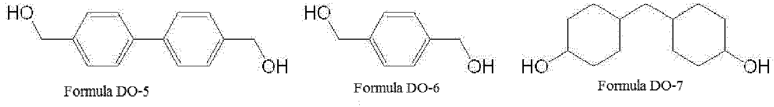

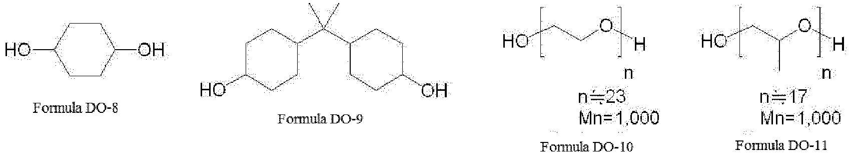

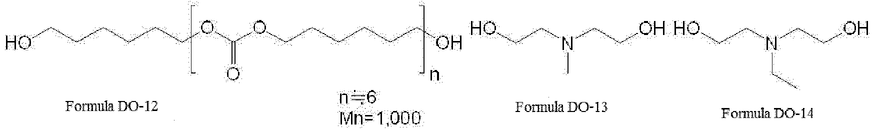

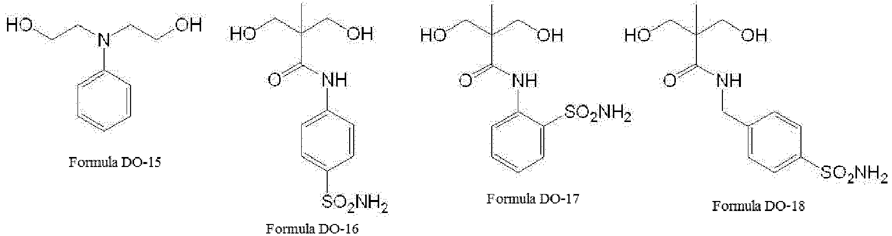

Further, the weight-average molecular weight (Mw) of the polyester containing a sulfonamide group in the main chain used in the present disclosure is preferably in a range of 10000 to 500000, more preferably in a range of 10000 to 200000, and still more preferably in a range of 20000 to 100000.

In the present disclosure, the weight-average molecular weight can be calculated by a standard polystyrene conversion method using gel permeation chromatography (GPC). A column filled with a polystyrene crosslinked gel (TSKgel SuperAWM-H; manufactured by Tosoh Corporation) can be used as the GPC column, and N-methylpyrrolidone (0.01 mol/L of each of phosphoric acid and lithium bromide) can be used as the GPC solvent.

Hereinafter, specific examples of the polyester containing a sulfonamide group in the main chain will be described. Further, the polyester containing a sulfonamide group in the main chain used in the present disclosure is not limited to the following specific examples.

Specific examples of the polyester containing a sulfonamide group in the main chain used in the present disclosure include compounds represented by Formulae PE-1 to PE-22.

In Formulae PE-1 to PE-22, the numerical values on the lower right side of [ ] respectively represent a containing molar ratio of a constitutional unit, the numerical values on the lower right side of ( ) respectively represent the number of repeating units in a polyalkyleneoxy group, and Mw represents the weight-average molecular weight.

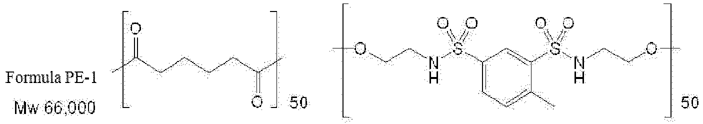

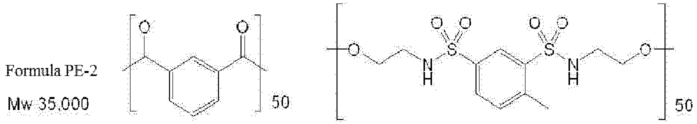

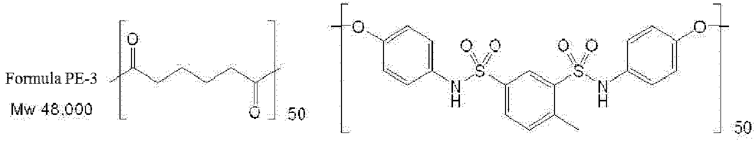

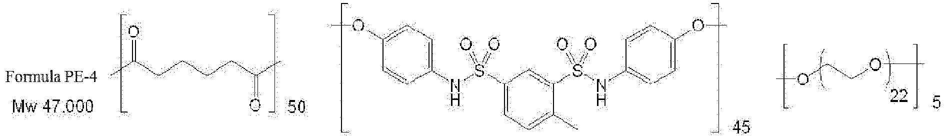

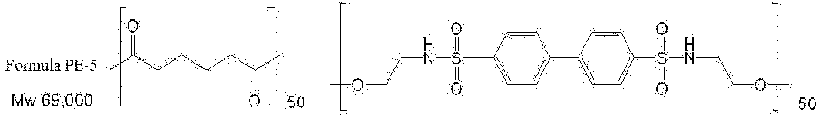

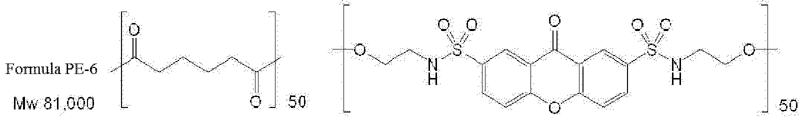

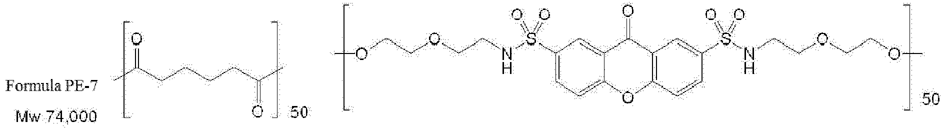

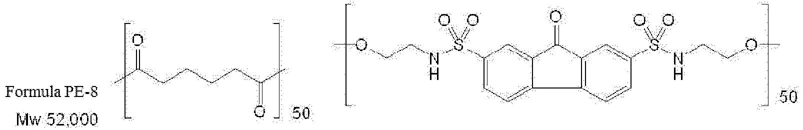

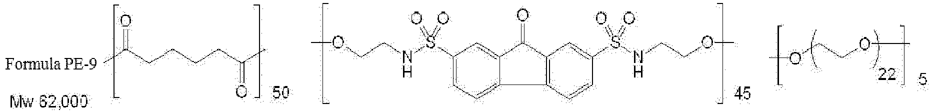

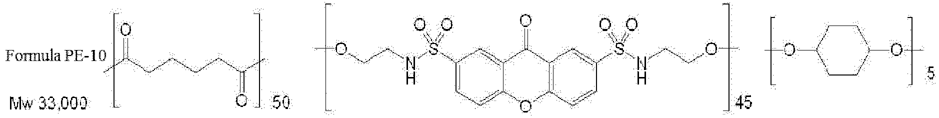

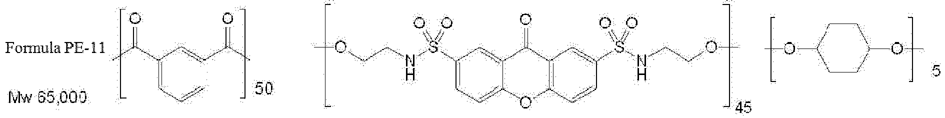

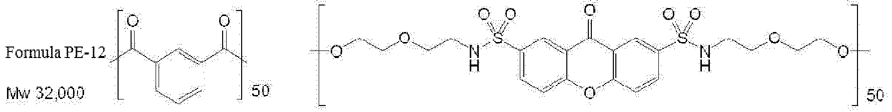

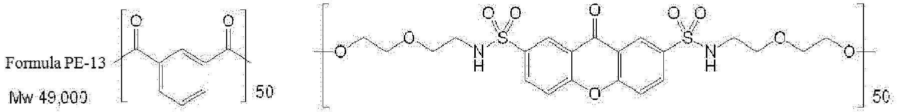

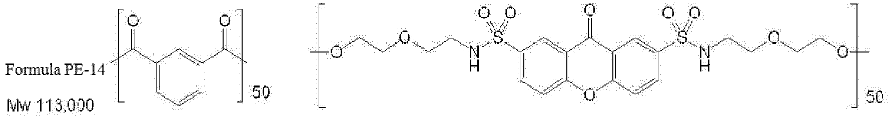

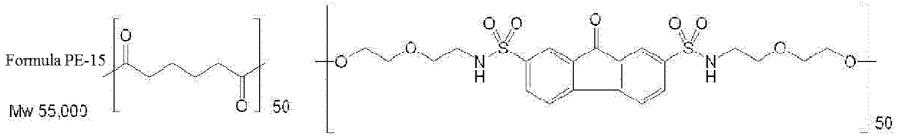

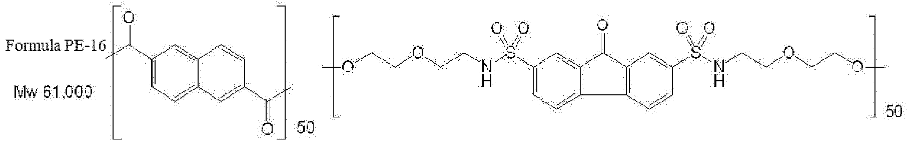

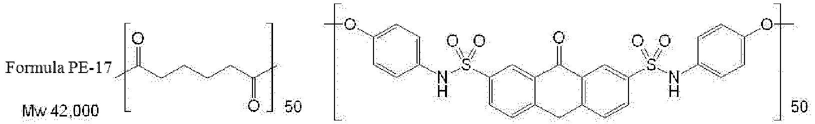

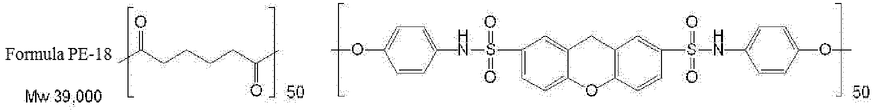

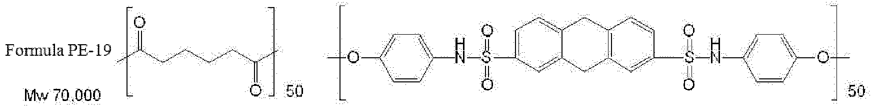

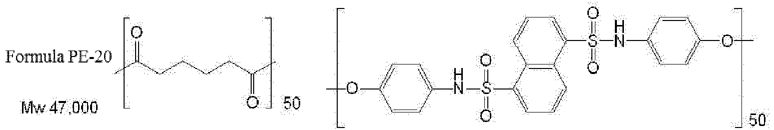

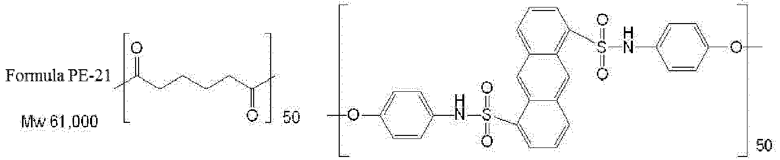

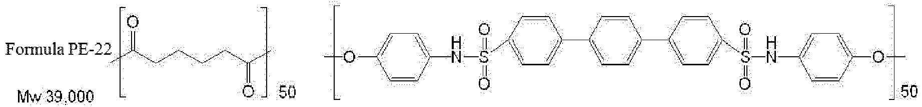

Further, the polyester represented by Formula PE-1 can also be regarded as polyester formed of each constitutional unit represented by Formula PE-1 '.

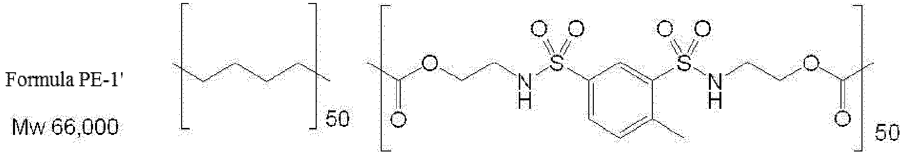

The polyester containing a sulfonamide group in the main chain, which is represented by Formulae PE-1 to PE-22, can be produced by a sequential polymerization reaction of a diol compound represented by Formula E-1 with any or both of a dicarboxylic acid compound represented by Formula E-2A and a bifunctional carboxylic acid halide compound represented by Formula E-2B and then with a diol compound represented by Formula E-3, listed in Table 1, as necessary.

**[Table 1]**

| | Diol compound represented by Formula E-1 | | Dicarboxylic acid compound represented by Formula E-2A | | Diol compound represented by Formula E-3 | | Weight-ave rage molecular weight |
|---|---|---|---|---|---|---|---|
| | Compound | Content (molar ratio) | Compound | Content (molar ratio) | Compound | Content (molar ratio) | |
| PE-1 | SA-1 | 50 | CA-2 | 50 | | | 66,000 |
| PE-2 | SA-1 | 50 | CA-9 | 50 | | | 35,000 |
| PE-3 | SA-2 | 50 | CA-2 | 50 | | | 48,000 |
| PE-4 | SA-2 | 45 | CA-2 | 50 | DO-10 | 5 | 47,000 |
| PE-5 | SA-25 | 50 | CA-2 | 50 | | | 69,000 |
| PE-6 | SA-28 | 50 | CA-2 | 50 | | | 81,000 |
| PE-7 | SA-31 | 50 | CA-2 | 50 | | | 74,000 |
| PE-8 | SA-32 | 50 | CA-2 | 50 | | | 52,000 |
| PE-9 | SA-32 | 45 | CA-2 | 50 | DO-10 | 5 | 62,000 |
| PE-10 | SA-28 | 45 | CA-2 | 50 | DO-8 | 5 | 33,000 |
| PE-11 | SA-28 | 45 | CA-9 | 50 | DO-8 | 5 | 65,000 |
| PE-12 | SA-31 | 50 | CA-9 | 50 | | | 32,000 |
| PE-13 | SA-31 | 50 | CA-9 | 50 | | | 49,000 |
| PE-14 | SA-31 | 50 | CA-9 | 50 | | | 113,000 |
| PE-15 | SA-33 | 50 | CA-2 | 50 | | | 55,000 |
| PE-16 | SA-33 | 50 | CA-11 | 50 | | | 61,000 |
| PE-17 | SA-9 | 50 | CA-2 | 50 | | | 42,000 |
| PE-18 | SA-11 | 50 | CA-2 | 50 | | | 39,000 |
| PE-19 | SA-12 | 50 | CA-2 | 50 | | | 70,000 |
| PE-20 | SA-15 | 50 | CA-2 | 50 | | | 47,000 |
| PE-21 | SA-18 | 50 | CA-2 | 50 | | | 61,000 |
| PE-22 | SA-19 | 50 | CA-2 | 50 | | | 39,000 |

Table 1 shows specific examples in a case where polyester is synthesized using a dicarboxylic acid compound, but the same polyester can be synthesized even using a carboxylic acid halide compound having the corresponding structure.

In the positive type photosensitive resin composition according to the present disclosure, the content of the polyester containing a sulfonamide group in the main chain is preferably in a range of 10% to 90% by mass, more preferably in a range of 20% to 85% by mass, and particularly preferably in a range of 30% to 80% by mass with respect to the total mass of the solid content in the positive type photosensitive resin composition. In a case where the content thereof is in the above-described range, the solubility of a non-image area in a positive type planographic printing plate precursor to be obtained in an alkali aqueous solution is excellent, and the chemical resistance and the printing durability of a planographic printing plate to be obtained are excellent. In addition, the total mass of the solid content in the positive type photosensitive resin composition indicates the amount obtained by removing volatile components such as a solvent.

### <Infrared absorbent>

The positive type photosensitive resin composition of the present disclosure contains an infrared absorbent.

The infrared absorbent is not particularly limited as long as it is a dye which generates heat by absorbing infrared light, and various dyes known as an infrared absorbent can be used.

As the infrared absorbent which can be used in the present disclosure, commercially available dyes or known dyes described in documents (for example, "Dye Handbook", compiled by the Society of Synthetic Organic Chemistry, published in 1970) can be used. Specifically, dyes such as azo dyes, metal complex azo dyes, pyrazolone azo dyes, anthraquinone dyes, phthalocyanine dyes, carbonium dyes, quinone imine dyes, methine dyes, and cyanine dyes are exemplified. In the present disclosure, among these dyes, a dye absorbing at least infrared light or near infrared light is preferable from the viewpoint of being suitable for use in laser emitting infrared light or near infrared light, and a cyanine dye is particularly preferable.

Examples of such a dye absorbing at least infrared light or near infrared light include the cyanine dyes described in JP1983-125246A (JP-S58-125246A), JP1984-84356A (JP-S59-84356A), JP-1984-202829A (JP-S59-202829A), or JP1985-78787A (JP-S60-78787A), the methine dyes described in JP1983-173696A (JP-S58-173696A), JP1983-181690A (JP-S58-181690A), or JP1983-194595A (JP-S58-194595A), the naphthoquinone dyes described in JP1983-112793A (JP-S58-112793A), JP1983-224793A (JP-S58-224793A), JP1984-48187A (JP-S59-48187A), JP1984-73996A (JP-S59-73996A), JP1985-52940A (JP-S60-52940A), or JP1985-63744A (JP-S60-63744A), the squarylium coloring agents described in JP1983-112792A (JP-S58-112792A), and the cyanine dyes described in GB434875B.

In addition, as the dye, the near infrared absorbing sensitizers described in US5156938A are also suitably used, also, the substituted aryl benzo(thio)pyrylium salts described in US3881924A, the trimethinecyanine thiapyrylium salts described in JP1982-142645A (JP-S57-142645A) (US4327169A), the pyrylium-based compounds described in JP1983-181051A (JP-S58-181051A), JP1983-220143A (JP-S58-220143A), JP1984-41363A (JP-S59-41363A), JP1984-84248A (JP-S59-84248A), JP1984-84249A (JP-S59-84249A), JP1984-146063A (JP-S59-146063A), or JP1984-146061A (JP-S59-146061A), the cyanine coloring agents described in JP1984-216146A (JP-S59-216146A), the pentamethinethiopyrylium salts described in US4283475A, or the pyrylium compounds described in JP1993-13514B (JP-H05-13514B) or JP1993-19702B (JP-H05-19702B) are used, and as commercially available products, Epolight III-178, Epolight III-130, Epolight III-125, or the like (manufactured by Epolin Inc.) is particularly preferably used.

In addition, particularly preferable another examples of the dye include near infrared absorbing dyes described as Formula (I) or (II) in US4756993A.

Among these dyes, examples of a particularly preferable dye include a cyanine coloring agent, a phthalocyanine dye, an oxonol dye, a squarylium coloring agent, a pyrylium salt, a thiopyrylium dye, and a nickel thiolate complex. Furthermore, in a case where a cyanine coloring agent represented by the following Formula (a) is used in the upper layer in the present disclosure, a high polymerization activity is given and the stability and the economic efficiency become excellent, and thus, the cyanine coloring agent is most preferable.

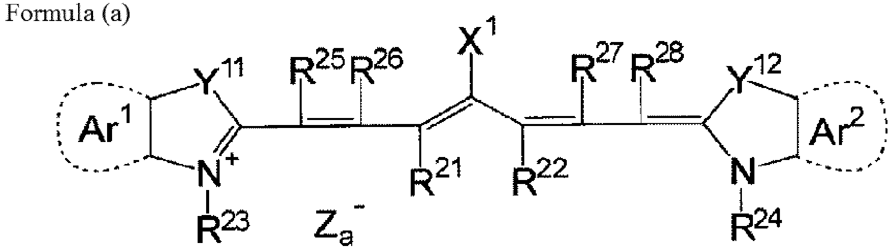

In Formula (a), X¹ represents a hydrogen atom, a halogen atom, a diarylamino group (-NPh₂), X²-L¹, or a group represented by Formula (b). X² represents an oxygen atom or a sulfur atom. L¹ represents a hydrocarbon group having 1 to 12 carbon atoms, an aromatic ring having a heteroatom, or a hydrocarbon group having 1 to 12 carbon atoms including a heteroatom. Here, the heteroatom represents N, S, O, a halogen atom, or Se.

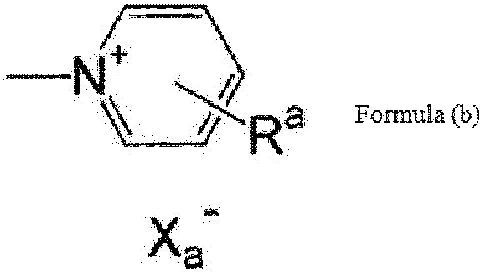

In Formula (b), Xa⁻ has the same definition as Za⁻ described below, and R^{a} represents a substituent selected from a hydrogen atom, an alkyl group, an aryl group, a substituted or unsubstituted amino group, and a halogen atom.

R²¹ and R²² each independently represent a hydrocarbon group having 1 to 12 carbon atoms. From the viewpoint of storage stability of the positive type photosensitive resin composition, each of R²¹ and R²² is preferably a hydrocarbon group having two or more carbon atoms, and R²¹ and R²² are particularly preferably bonded to each other to form a 5-membered ring or a 6-membered ring.

Ar¹ and Ar² may be the same as or different from each other, and Ar¹ and Ar² each represent an aromatic hydrocarbon group which may have a substituent. Examples of a preferable aromatic hydrocarbon group include a benzene ring and a naphthalene ring. In addition, examples of a preferable substituent include a hydrocarbon group having 12 or less carbon atoms, a halogen atom, and an alkoxy group having 12 or less carbon atoms.

Y¹¹ and Y¹² may be the same as or different from each other, and Y¹¹ and Y¹² each represent a sulfur atom or a dialkyl methylene group having 12 or less carbon atoms. R²³ and R²⁴ may be the same as or different from each other, and R²³ and R²⁴ each represent a hydrocarbon group having 20 or less carbon atoms which may have a substituent. Examples of a preferable substituent include an alkoxy group having 12 or less carbon atoms, a carboxyl group, and a sulfo group.

R²⁵, R²⁶, R²⁷, and R²⁸ may be the same as or different from each other, and R²⁵, R²⁶, R²⁷, and R²⁸ each represent a hydrogen atom or a hydrocarbon group having 12 or less carbon atoms. From the viewpoint of availability of a raw material, each of R²⁵, R²⁶, R²⁷, and R²⁸ is preferably a hydrogen atom. In addition, Za⁻ represents a counter anion. Here, the cyanine coloring agent represented by Formula (a) has an anionic substituent in the structure thereof, and in a case where neutralization of the charge is not necessary, Za⁻ is not necessary. From the viewpoint of storage stability of the positive type photosensitive resin composition, Za⁻ is preferably a halide ion, a perchlorate ion, a tetrafluoroborate ion, a hexafluorophosphate ion, or a sulfonate ion, and particularly preferably a perchlorate ion, a hexafluorophosphate ion, or an arylsulfonate ion.

Specific examples of the cyanine coloring agent represented by Formula (a) which can be suitably used include the cyanine coloring agents described in paragraphs 0017 to 0019 of JP2001-133969A, paragraphs 0012 to 0038 of JP2002-40638A, and paragraphs 0012 to 0023 of JP2002-23360A.

The infrared absorbent contained in the upper layer is particularly preferably a cyanine dye A shown below.

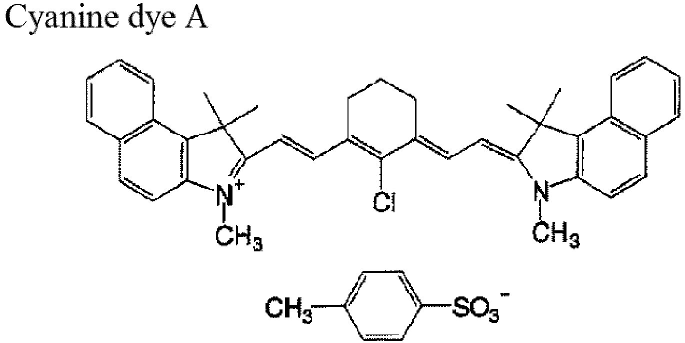

The content of the infrared absorbent in the positive type photosensitive resin composition according to the present disclosure is preferably in a range of 0.01% to 50% by mass, more preferably in a range of 0.1% to 30% by mass, and particularly preferably in a range of 1.0% to 30% by mass, with respect to the total mass of the solid content in the positive type photosensitive resin composition. In a case where the content thereof is 0.01% by mass or greater, the layer becomes high sensitive, and in a case where the content thereof is 50% by mass or less, the uniformity of the layer is excellent and the durability of the layer is excellent. In addition, the total mass of the solid content in the positive type photosensitive resin composition indicates the amount obtained by removing volatile components such as a solvent.

### <Other alkali-soluble resins>

In the present disclosure, the "alkali-soluble" means "being solubilized by a treatment for a standard development time in an alkali aqueous solution with a pH of 8.5 to 13.5".

Although the alkali-soluble resin other than the polyester containing a sulfonamide group in the main chain, used in the positive type photosensitive resin composition according to the present disclosure is not particularly limited as long as it has a characteristic of being dissolved by contact with an alkali developer, it is preferable that the alkali-soluble resin has an acidic functional group such as a phenolic hydroxyl group, a sulfonic acid group, a phosphoric acid group, a sulfonamide group, or an active imide group in any or both of the main chain and a side chain in the polymer, a resin including 10 mol% or greater of a monomer having such an acidic functional group imparting alkali-solubility is exemplified, and a resin including 20 mol% or greater is more preferable. In a case where the copolymerization component of the monomer imparting alkali-solubility is 10 mol% or greater, sufficient alkali-solubility is obtained, and developability is excellent.

In addition, as the alkali-soluble resin, a novolac resin is also preferably exemplified.

As the novolac resin which can be used in the present disclosure, novolac resins such as a phenol formaldehyde resin, an m-cresol formaldehyde resin, a p-cresol formaldehyde resin, an m-/p- mixed cresol formaldehyde resin, a phenol/cresol (which may be any mixture of m-, p-, and m-/p-) mixed formaldehyde resin or pyrogallol acetone resins are preferably exemplified.

In addition, a polycondensate of phenol having an alkyl group having 3 to 8 carbon atoms as a substituent and formaldehyde, such as a t-butyl phenol formaldehyde resin or an octyl phenol formaldehyde resin, as described in US4123279A, is exemplified. In addition, the weight-average molecular weight (Mw) thereof is preferably 500 or greater, and more preferably 1,000 to 700,000. In addition, the number average molecular weight (Mn) thereof is preferably 500 or greater, and more preferably 750 to 650,000. The dispersity (weight-average molecular weight/number average molecular weight) is preferably 1.1 to 10.

Other alkali-soluble resins preferably have a weight-average molecular weight of 2,000 or greater and a number average molecular weight of 500 or greater, and more preferably have a weight-average molecular weight of 5,000 to 300,000 and a number average molecular weight of 800 to 250,000. The dispersity (weight-average molecular weight/number average molecular weight) of other alkali-soluble resins is preferably 1.1 to 10.

Other alkali-soluble resins included in the positive type photosensitive resin composition according to the present disclosure as desired may be used alone or in combination of two or more kinds thereof.

The content of other alkali-soluble resins in the positive type photosensitive resin composition according to the present disclosure is preferably 0% to 80% by mass and more preferably 0% to 70% by mass with respect to the total mass of the solid content in the positive type photosensitive resin composition. In addition, 80 parts by mass or less thereof are preferably included with respect to 100 parts by mass of the polyester containing a sulfonamide group in the main chain used in the present disclosure.

### <Acid generator>

It is preferable that the positive type photosensitive resin composition according to the present disclosure contains an acid generator from the viewpoint of improving the sensitivity.

The acid generator in the present disclosure is a compound which generates an acid by light or heat, and indicates a compound which generates an acid due to decomposition by irradiation with infrared rays or heating at 100°C or higher. The acid generated is preferably a strong acid having a pKa of 2 or less such as sulfonic acid or hydrochloric acid. The permeability of a developer into the image recording layer of the exposed portion is increased and the solubility of the image recording layer in an alkali aqueous solution is further improved due to an acid generated from this acid generator.

Examples of the acid generator suitably used in the present disclosure include onium salts such as an iodonium salt, a sulfonium salt, a phosphonium salt, and a diazonium salt. Specifically, the compounds described in US4708925A or JP1995-20629A (JP-H07-20629A) can be exemplified. In particular, an iodonium salt, a sulfonium salt, or a diazonium salt, which has a sulfonate ion as a counter ion, is preferable. As the diazonium salt, the diazonium compound described in US3867147A, the diazonium compound described in US2632703A, or the diazo resins described in JP1989-102456A (JP-H01-102456A) or JP1989-102457A (JP-H01-102457A) are also preferable. In addition, the benzyl sulfonates described in US5135838A or US5200544A are also preferable. Furthermore, the active sulfonic acid esters or the disulfonyl compounds described in JP1990-100054A (JP-H02-100054A), JP1990-100055A (JP-H02-100055A), or JP1997-197671A (JP-H09-197671A) are also preferable. In addition, the haloalkyl-substituted S-triazines described in JP1995-271029A(JP-H07-271029A) are also preferable.

Furthermore, the compound described as an "acid precursor" in JP1996-220752A (JP-H08-220752A) or the compound described as "(a) a compound which can generate an acid by irradiation with active light" in JP1997-171254A (JP-H09-171254A) can also be applied as the acid generator of the present disclosure.

Among these, from the viewpoint of sensitivity and stability, an onium salt compound is preferably used as an acid generator. The onium salt compound will be described below.

As the onium salt compound which can be suitably used in the present disclosure, compounds known as a compound which generates an acid due to decomposition by infrared ray exposure or heat energy generated from the infrared absorbent by exposure can be exemplified. As the onium salt compound suitable in the present disclosure, from the viewpoint of sensitivity, known thermal polymerization initiators or compounds having a bond with small bond dissociation energy and having an onium salt structure described below can be exemplified.

Examples of the onium salt suitably used in the present disclosure include known diazonium salts, iodonium salts, sulfonium salts, ammonium salts, pyridinium salts, and azinium salts, and among these, sulfonate of triarylsulfonium or diaryliodonium, carboxylate, BF₄⁻, PF₆⁻, or ClO₄⁻ is preferable.

Examples of the onium salt which can be used as an acid generator in the present disclosure include onium salts represented by the following Formulae (III) to (V).

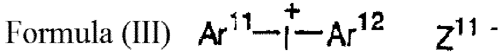

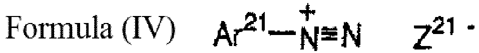

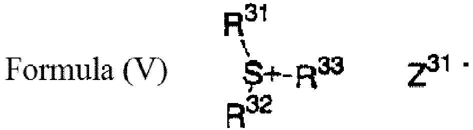

In Formula (III), Ar¹¹ and Ar¹² each independently represent an aryl group having 20 or less carbon atoms which may have a substituent. Examples of a preferable substituent in a case where the aryl group has a substituent include a halogen atom, a nitro group, an alkyl group having 12 or less carbon atoms, an alkoxy group having 12 or less carbon atoms, and an aryloxy group having 12 or less carbon atoms. Z¹¹⁻ represents a counter ion selected from the group consisting of a halogen ion, a perchlorate ion, a tetrafluoroborate ion, a hexafluorophosphate ion, a sulfonate ion, or a sulfonate ion having a fluorine atom such as a perfluoroalkyl sulfonate ion, and a perchlorate ion, a hexafluorophosphate ion, an aryl sulfonate ion, or a perfluoroalkyl sulfonic acid is preferable.

In Formula (IV), Ar²¹ represents an aryl group having 20 or less carbon atoms which may have a substituent. Examples of a preferable substituent include a halogen atom, a nitro group, an alkyl group having 12 or less carbon atoms, an alkoxy group having 12 or less carbon atoms, an aryloxy group having 12 or less carbon atoms, an alkylamino group having 12 or less carbon atoms, a dialkylamino group having 12 or less carbon atoms, an arylamino group having 12 or less carbon atoms, and a diarylamino group having 12 or less carbon atoms. Z²¹⁻ represents a counter ion having the same meaning as Z¹¹⁻.

In Formula (V), R³¹, R³², and R³³ may be the same as or different from each other, and R³¹, R³², and R³³ each represent a hydrocarbon group having 20 or less carbon atoms which may have a substituent. Examples of a preferable substituent include a halogen atom, a nitro group, an alkyl group having 12 or less carbon atoms, an alkoxy group having 12 or less carbon atoms, and an aryloxy group having 12 or less carbon atoms. Z³¹⁻ represents a counter ion having the same meaning as Z¹¹⁻.

In the present disclosure, specific examples of onium salts (OI-1 to OI-10) represented by Formula (III), onium salts (ON-1 to ON-5) represented by Formula (IV), and onium salts (OS-1 to OS-6) represented by Formula (V) which can be suitably used in the present invention are exemplified below.

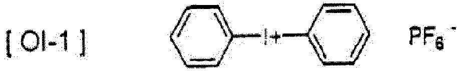

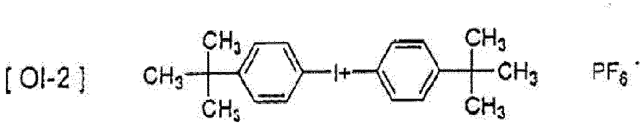

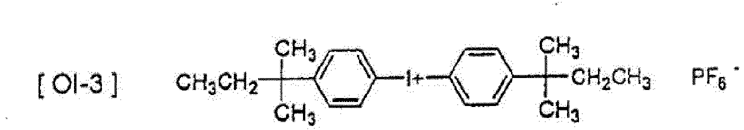

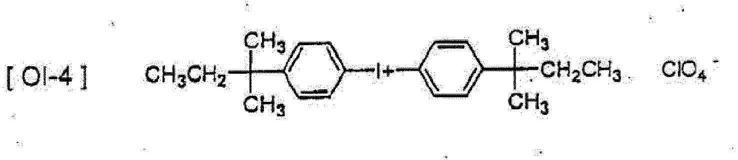

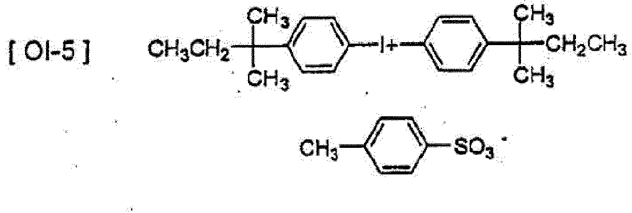

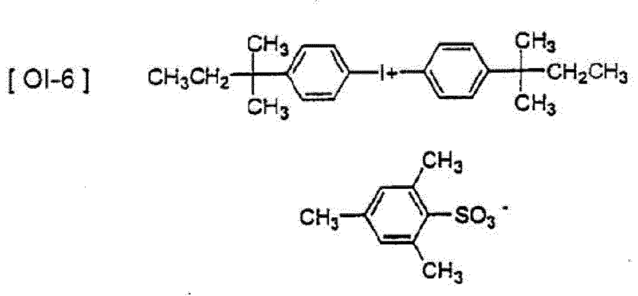

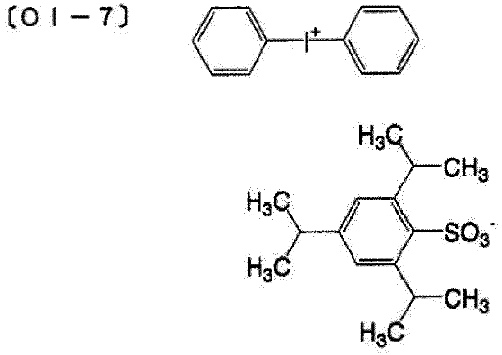

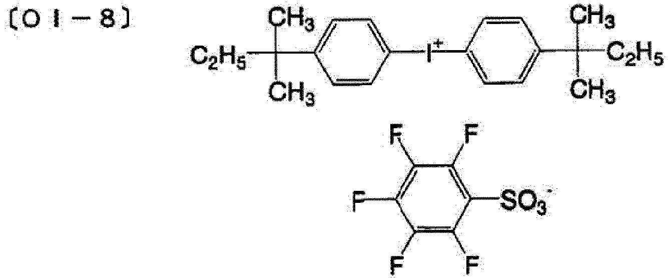

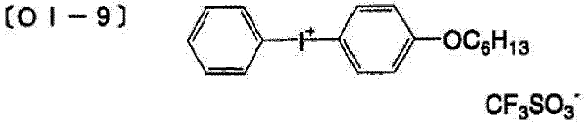

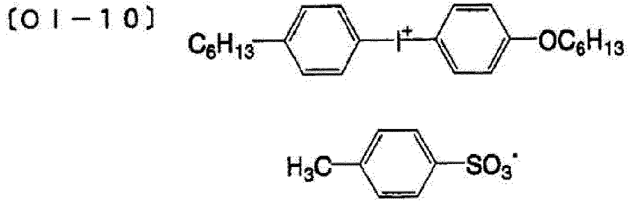

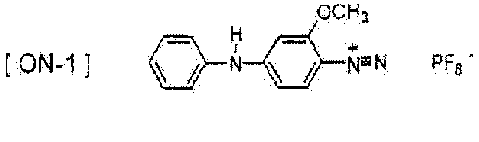

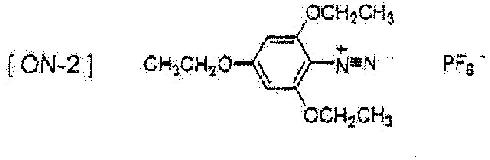

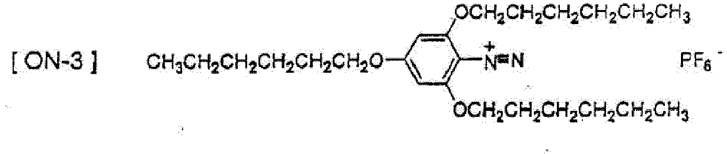

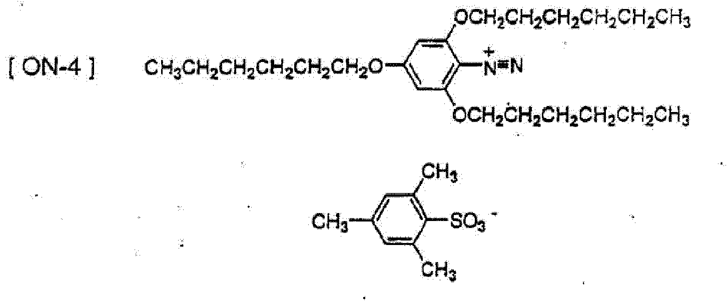

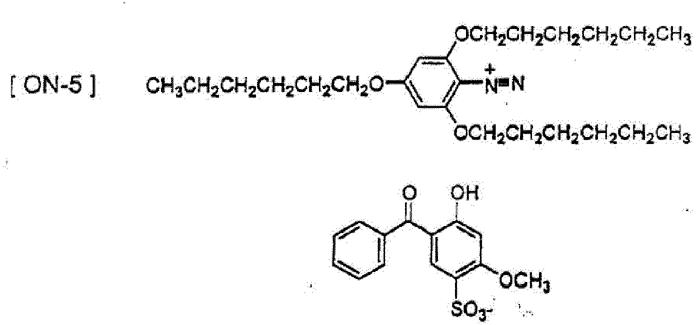

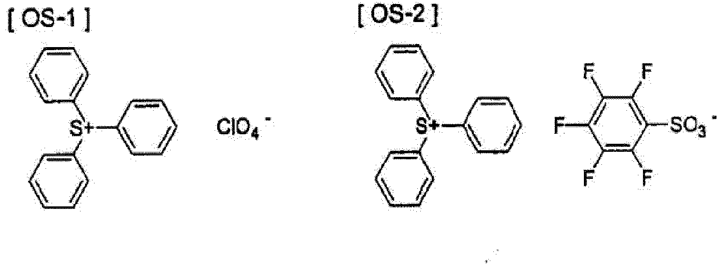

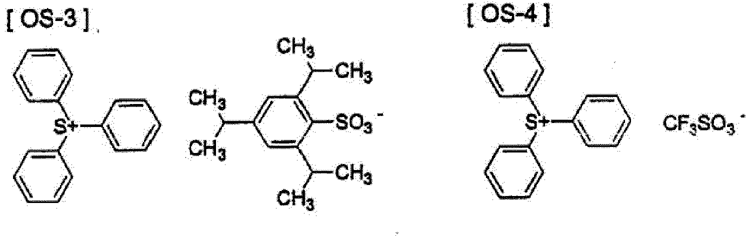

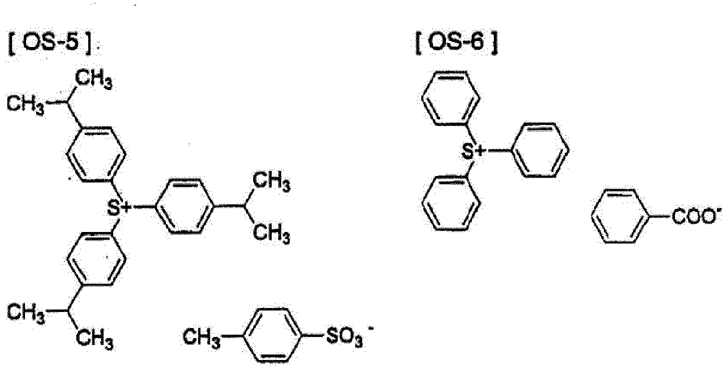

In addition, as another example of the compounds represented by each of Formula (III) to (V), the compounds described as an example of a radical polymerization initiator in paragraphs 0036 to 0045 of JP2008-195018A can be suitably used as an acid generator in the present disclosure.

Another example of a preferable onium salt as the acid generator used in the present disclosure includes an azinium salt compound represented by the following Formula VI.

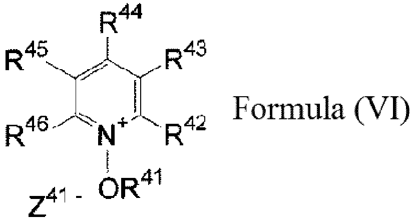

In Formula VI, R⁴¹, R⁴², R⁴¹, R⁴⁴, R⁴⁵, and R⁴⁶ may be the same as or different from each other, and R⁴¹, R⁴², R⁴³, R⁴⁴, R⁴⁵, and R⁴⁶ each represent a hydrogen atom, a halogen atom, or a monovalent substituent.

Examples of the monovalent substituent include a halogen atom, an amino group, a substituted amino group, a substituted carbonyl group, a hydroxyl group, a substituted oxy group, a thiol group, a thioether group, a silyl group, a nitro group, a cyano group, an alkyl group, an alkenyl group, an aryl group, a heterocyclic group, a sulfo group, a substituted sulfonyl group, a sulfonate group, a substituted sulfinyl group, a phosphono group, a substituted phosphono group, a phosphonate group, and a substituted phosphonate group, and in the case of being introducible, each of R⁴¹, R⁴², R⁴³, R⁴⁴, R⁴⁵, and R⁴⁶ may further have a substituent.

A compound (multimerized form) including two or more cation portions in the molecule as a result of bonding of the skeletons (cation portions) having a specific structure in the compound represented by Formula (VI) to each other through R⁴¹ is also included in examples of the compound represented by Formula (VI), and such a compound is also suitably used.

Z⁴¹⁻ represents a counter ion having the same meaning as Z¹¹⁻.

Specific examples of the azinium salt compound represented by Formula (VI) include the compounds described in paragraphs 0047 to 0056 of JP2008-195018A.

In addition, a compound group having an N-O bond described in JP1988-138345A (JP-S63-138345A), JP1988-142345A (JP-S63-142345A), JP1988-142346A (JP-S63-142346A), JP1988-143537A (JP-S63-143537A), or JP1971-42363B (JP-S46-42363B) is also suitably used as the acid generator in the present invention.

More preferable examples of the acid generator which can be used in the present disclosure include the following compounds (PAG-1) to (PAG-5).

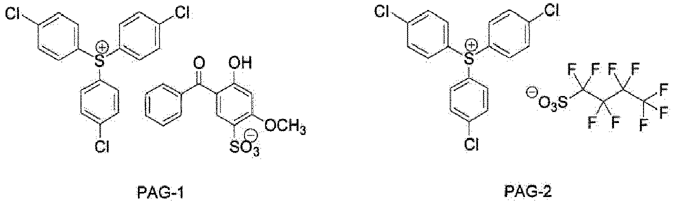

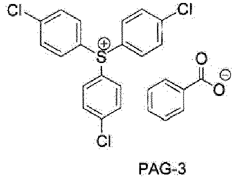

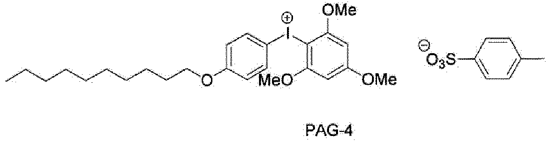

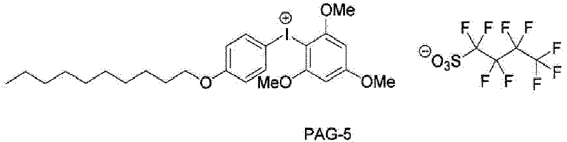

In a case where these acid generators are contained in the positive type photosensitive resin composition according to the present disclosure, these compounds may be used alone or in combination of two or more types thereof.

The content of acid generator is preferably in a range of 0.01% to 50% by mass, more preferably in a range of 0.1% to 40% by mass, and still more preferably in a range of 0.5% to 30% by mass with respect to the total mass of the solid content in the positive type photosensitive resin composition. In a case where the content is within the above-described range, improvement of sensitivity which is the effect of the addition of an acid generator is observed, and an occurrence of a residual film in a non-image area is suppressed.

### <Acid proliferative agent>

An acid proliferative agent may be contained in the positive type photosensitive resin composition of the present disclosure. The acid proliferative agent in the present invention is a compound substituted with a residue of a relatively strong acid, and a compound which newly generates an acid by being easily released in the presence of an acid catalyst. That is, the compound is decomposed by an acid catalyzed reaction, and generates an acid (hereinafter, referred to as ZOH in formulae) again. Since one or more acids per reaction are increased, and with the progress of the reaction, the acid concentration is increasingly increased, sensitivity is dramatically improved. The intensity of this generated acid is 3 or less as an acid dissociation constant (pKa), and preferably 2 or less. In the case of a weaker acid than this, it is not possible to cause the elimination reaction by an acid catalyst.

Examples of the acid used in such an acid catalyst include dichloroacetic acid, trichloroacetic acid, methanesulfonic acid, ethanesulfonic acid, benzenesulfonic acid, p-toluenesulfonic acid, naphthalenesulfonic acid, and phenyl sulfonic acid.

As the acid proliferative agent, the acid proliferative agents described in WO95/29968A, WO98/24000A, JP1996-305262A (JP-H08-305262A), JP1997-34106A (JP-H09-34106A), JP1996-248561A (JP-H08-248561A), JP1996-503082A (JP-H08-503082A), US5445917A, JP1996-503081A (JP-H08-503081A), US5534393A, US5395736A, US5741630A, US5334489A, US5582956A, US5578424A, US5453345A, US5445917A, EP665960B, EP757628B, EP665961B, US5667943A, or JP1998-1598A (JP-H10-1598A) can be used alone or in combination of two or more types thereof.

Specific preferred examples of the acid proliferative agent in the present disclosure include the compounds described in paragraphs 0056 to 0067 of JP2001-66765A. Among these, the following compounds described as an exemplary compound (ADD-1), (ADD-2), or (ADD-3) can be suitably used.

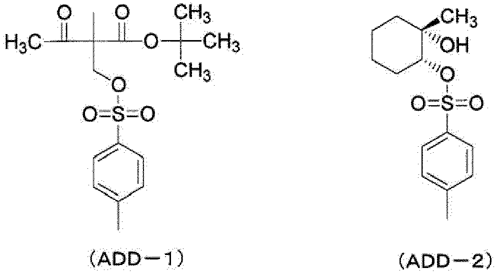

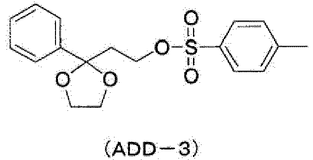

The content of the acid proliferative agent is in a range of 0.01% to 20% by mass, preferably in a range of 0.01% to 10% by mass, and more preferably in a range of 0.1% to 5% by mass with respect to the total mass of the solid content of the positive type photosensitive resin composition. In a case where the content of the acid proliferative agent is in the above-described range, effects of adding acid proliferative agent is sufficiently obtained, improvement in sensitivity is achieved, and film hardness reduction of an image area is suppressed.

### <Other additives>

The positive type photosensitive resin composition according to the present disclosure may include a development accelerator, a surfactant, a print-out agent/colorant, a plasticizer, or a wax agent, as other additives.

### [Development accelerator]

For the purpose of improving the sensitivity, acid anhydrides, phenols, or organic acids may be added to the positive type photosensitive resin composition according to the present disclosure.

As the acid anhydrides, cyclic acid anhydride is preferable, and specifically, as the cyclic acid anhydride, phthalic anhydride, tetrahydrophthalic anhydride, hexahydrophthalic anhydride, 3,6-endooxytetrahydrophthalic anhydride, tetrachlorophthalic anhydride, maleic anhydride, chloromaleic anhydride, α-phenylmaleic anhydride, succinic anhydride, or pyromellitic anhydride described in US4115128A can be used. As the non-cyclic acid anhydride, acetic anhydride is exemplified.

Examples of the phenols include bisphenol A, 2,2'-bishydroxysulfone, p-nitrophenol, p-ethoxyphenol, 2,4,4'-trihydroxybenzophenone, 2,3,4-trihydroxybenzophenone, 4-hydroxybenxophenone, 4,4',4"-trihydroxytriphenyl methane, and 4,4',3",4"-tetrahydroxy-3,5,3',5'-tetramethyltriphenyl methane.

The organic acids are described in JP1985-88942A (JP-S60-88942A), JP1990-96755A (JP-H02-96755A), or the like, and specific examples thereof include p-toluenesulfonic acid, dodecylbenzenesulfonic acid, p-toluenesulfinic acid, ethyl sulfate, phenylphosphonic acid, phenylphosphinic acid, phenyl phosphate, diphenyl phosphate, benzoic acid, isophthalic acid, adipic acid, p-toluic acid, 3,4-dimethoxybenzoic acid, phthalic acid, terephthalic acid, 4-cyclohexene-1,2-dicarboxylic acid, erucic acid, lauric acid, n-undecanoic acid, and ascorbic acid. The ratio of the mass of the acid anhydrides, the phenols, and the organic acids to the total mass of the solid content in the positive type photosensitive resin composition is preferably in a range of 0.05% to 20% by mass, more preferably in a range of 0.1% to 15% by mass, and particularly preferably in a range of 0.1% to 10% by mass.

### <Surfactant>

To improve coating properties and stability of a treatment with respect to development conditions, a nonionic surfactant as described in JP1987-251740A (JP-S62-251740A) or JP1991-208514A (JP-H03-208514A), an amphoteric surfactant as described in JP1984-121044A (JP-S59-121044A) or JP1992-13149A (JP-H04-13149A), or a fluorine-containing monomer copolymer such as JP1987-170950A (JP-S62-170950A), JP1999-288093A (JP-H11-288093A), or JP2003-57820A can be added to the positive type photosensitive resin composition according to the present disclosure.

Specific examples of the nonionic surfactant include sorbitan tristearate, sorbitan monopalmitate, sorbitan trioleate, monoglyceride stearate, and polyoxyethylenenonylphenyl ether.

Specific examples of the amphoteric surfactant include alkyl di(aminoethyl)glycine, alkylpolyaminoethylglycine hydrochloride, 2-alkyl-N-carboxyethyl-N-hydroxyethyl imidazolinium betaine, and an N-tetradecyl-N,N-betaine type (for example, product name "AMOGEN K", manufactured by Dai-ichi Kogyo Seiyaku Co., Ltd.).

The ratio of the mass of the surfactant to the total mass of the solid content in the positive type photosensitive resin composition is preferably in a range of 0.01% to 15% by mass, more preferably in a range of 0.01% to 5% by mass, and still more preferably in a range of 0.05% to 2.0% by mass.

### [Print-out agent/colorant]

A print-out agent for obtaining a visible image immediately after heating by exposure or a dye or a pigment as an image colorant can be added to the positive type photosensitive resin composition according to the present disclosure.

Examples of the print-out agent and the colorant are described in detail in paragraphs 0122 and 0123 of JP2009-229917A, and the compounds described here can be applied to the positive type photosensitive resin composition according to the present disclosure.

The dye is preferably added in a ratio of 0.01% to 10% by mass and more preferably added in a ratio of 0.1% to 3% by mass, with respect to the total mass of the solid content in the positive type photosensitive resin composition.

### [Plasticizer]

To impart flexibility or the like to the coating film, a plasticizer may be added to the positive type photosensitive resin composition according to the present disclosure. For example, butylphthalyl polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl oleate, or an oligomer or a polymer of acrylic acid or methacrylic acid is used.

These plasticizers are preferably added in a ratio of 0.5% to 10% by mass and more preferably added in a ratio of 1.0% to 5% by mass, with respect to the total mass of the solid content in the positive type photosensitive resin composition.

### [Wax agent]

For the purpose of imparting resistance to scratches, a compound for reducing the coefficient of static friction of the surface can also be added to the positive type photosensitive resin composition according to the present disclosure. Specifically, the compounds having an ester of a long chain alkyl carboxylic acid as described in US6117913A, JP2003-149799A, JP2003-302750A, or JP2004-12770A can be exemplified.

The content of the wax agent is preferably in a range of 0.1% to 10% by mass and more preferably in a range of 0.5% to 5% by mass with respect to the total mass of the solid content in the positive type photosensitive resin composition.

### <Compositional ratio of respective components>

The content of the polyester containing a sulfonamide group in the main chain is preferably 10% to 90% by mass, the content of the infrared absorbent is preferably 0.01% to 50% by mass, the content of other alkali-soluble resins is preferably 0% to 80% by mass, the content of the acid generator is preferably 0% to 30% by mass, the content of the acid proliferative agent is preferably 0% to 20% by mass, the content of the development accelerator is preferably 0% to 20% by mass, the content of the surfactant is preferably 0% to 5% by mass, the content of the print-out agent/colorant is preferably 0% to 10% by mass, the content of the plasticizer is preferably 0% to 10% by mass, and the content of the wax agent is preferably 0% to 10% by mass, with respect to the total mass of the solid content of the positive type photosensitive resin composition according to the present disclosure.

The positive type photosensitive resin composition according to the present disclosure can be applied to various fields requiring resin pattern formation excellent in durability, for example, various fields such as a resist, a display, a planographic printing plate precursor, and the like, and since the photosensitive resin composition can be recorded with excellent sensitivity and has excellent image formability, and the durability of the image area formed of the composition is excellent, by applying to an infrared sensitive positive type planographic printing plate precursor described in detail below, the effects of the present disclosure can become significant.

### (Positive type planographic printing plate precursor)

The positive type planographic printing plate precursor according to the present disclosure has an image recording layer containing the positive type photosensitive resin composition according to the present disclosure, on a support having a hydrophilic surface.

Further, the positive type planographic printing plate precursor according to the present disclosure is a positive type planographic printing plate precursor including an image recording layer which has an underlayer and an upper layer in this order on the support having a hydrophilic surface, and the positive type photosensitive resin composition is preferably contained in at least one of the underlayer or the upper layer, more preferably contained in the underlayer or the upper layer, and still more preferably contained only in the underlayer.

### <Image recording layer>

The image recording layer used in the present disclosure can be formed by dissolving respective components of the positive type photosensitive resin composition in a solvent and applying the resulting product to a suitable support.

Examples of the solvent used here include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethyl urea, N-methylpyrrolidone, dimethyl sulfoxide, sulfolane, γ-butyrolactone, and toluene, and the present invention is not limited thereto. These solvents are used alone or in a mixture.

### <Formation of underlayer and upper layer>

In addition, it is preferable that the positive type planographic printing plate precursor used in the present disclosure is a positive type planographic printing plate precursor (hereinafter, also referred to as a "positive type planographic printing plate precursor having a two-layer structure") including an image recording layer that has an underlayer and an upper layer in this order, on the support.

The underlayer and the upper layer are preferably separately formed in principle.

As the method of separately forming the two layers, for example, a method of using the difference in the solvent solubilities between the components included in the underlayer and the components included in the upper layer and a method of rapidly drying and removing the solvent after application to the upper layer are exemplified. Since by using the latter method in combination, the separation between the layers is more favorably performed, the method is preferable.

These methods will be described in detail below, but the method of separately applying to the two layers is not limited thereto.

In the method of using the difference in the solvent solubilities between the components included in the underlayer and the components included in the upper layer, in a case where applying a coating solution for an upper layer, a solvent system in which all the components included in the underlayer are insoluble is used. Thus, even in a case where two-layer coating is performed, a coating film can be formed such that each layer thereof is clearly separated. For example, by selecting a component insoluble in a solvent such as methyl ethyl ketone or 1-methoxy-2-propanol which dissolves an alkali-soluble resin which is the upper layer component, as the underlayer component, applying to the underlayer and drying using a solvent system which dissolves the underlayer component, dissolving the alkali-soluble resin-based upper layer in methyl ethyl ketone or 1-methoxy-2-propanol, and applying the resulting product and drying, bilayering is possible.

Next, the method of very rapidly drying the solvent after application to the second layer (upper layer) can be achieved by blowing high-pressure air from a slit nozzle provided substantially at a right angle with respect to the running direction of the web, applying heat energy as conductive heat from the lower surface of the web by a roll (heating roll) into which a heating medium such as steam has been supplied, or combining these.

The positive type photosensitive resin composition according to the present disclosure is preferably included any or both of the upper layer and the underlayer and more preferably included only in the underlayer.

The coating amount after drying of the underlayer components to be applied to the support of the positive type planographic printing plate precursor according to the present disclosure is preferably in a range of 0.5 to 4.0 g/m² and more preferably in a range of 0.6 to 2.5 g/m². In a case where the coating amount is 0.5 g/m² or greater, printing durability is excellent, and in a case where the coating amount is 4.0 g/m² or less, image reproducibility and sensitivity are excellent.

In addition, the coating amount after drying of the upper layer component is preferably 0.05 to 1.0 g/m² and more preferably 0.08 to 0.7 g/m². In a case where the coating amount is 0.05 g/m² or greater, development latitude and scratch resistance are excellent, and in a case where the coating amount is 1.0 g/m² or less, sensitivity is excellent.

The coating amount after drying of the underlayer and the upper layer is preferably in a range of 0.6 to 4.0 g/m² and more preferably in a range of 0.7 to 2.5 g/m². In a case where the coating amount is 0.6 g/m² or greater, printing durability is excellent, and in a case where the coating amount is 4.0 g/m² or less, image reproducibility and sensitivity are excellent.

### <Upper layer>

The upper layer of the positive type planographic printing plate precursor having a two-layer structure according to the present disclosure may be a layer containing the positive type photosensitive resin composition of the present invention, but it is preferable that the upper layer thereof is a layer containing other resin compositions other than the positive type photosensitive resin composition according to the present disclosure.

It is preferable that the upper layer of the positive type planographic printing plate precursor having a two-layer structure according to the present disclosure is an infrared sensitive positive type image recording layer whose solubility in an alkali aqueous solution is improved by heat.

The mechanism of improving the solubility in alkali aqueous solution by heat in the upper layer is not particularly limited, and any one can be used as long as it includes a binder resin and improves the solubility of the heated region. As the heat used in image formation, the heat generated in a case where the underlayer including an infrared absorbent is exposed is exemplified.

Preferable examples of the upper layer of which the solubility in an alkali aqueous solution is improved by heat include a layer including an alkali-soluble resin having a hydrogen-bonding capacity such as novolac or urethane, a layer including a water-insoluble and alkali-soluble resin and a compound having a dissolution suppressing action, and a layer including an ablation-possible compound.

In addition, by further adding an infrared absorbent to the upper layer, the heat generated from the upper layer can also be used in image formation. Preferable examples of the constitution of the upper layer including an infrared absorbent include a layer including an infrared absorbent, a water-insoluble and alkali-soluble resin, and a compound having a dissolution suppressing action, and a layer including an infrared absorbent, a water-insoluble and alkali-soluble resin, and an acid generator.

### [Water-insoluble and alkali-soluble resin]

It is preferable that the upper layer according to the present disclosure contains a water-insoluble and alkali-soluble resin. By containing the water-insoluble and alkali-soluble resin, an interaction is formed between the polar groups of the infrared absorbent and the water-insoluble and alkali-soluble resin, and a layer having a positive type photosensitivity is formed.

Typical water-insoluble and alkali-soluble resin will be described below in detail, and among these, a polyamide resin, an epoxy resin, a polyacetal resin, an acrylic resin, a methacrylic resin, a polystyrene-based resin, and a novolac-type phenolic resin are preferably exemplified.

The water-insoluble and alkali-soluble resin which can be used in the present disclosure is not particularly limited as long as it has a characteristic of being dissolved by contact with an alkali developer, and a homopolymer containing an acidic group in any or both of the main chain and a side chain in the polymer, a copolymer thereof, or a mixture thereof is preferable.

Such a water-insoluble and alkali-soluble resin having an acidic group preferably has a functional group such as a phenolic hydroxyl group, a carboxyl group, a sulfonate group, a phosphate group, a sulfonamide group, or an active imide group. Therefore, such a resin can be suitably produced by copolymerizing a monomer mixture including one or more ethylenically unsaturated monomers having a functional group described above. As the ethylenically unsaturated monomer having a functional group described above, in addition to acrylic acid and methacrylic acid, a compound represented by the following formula and a mixture thereof can be preferably exemplified. Moreover, in the following formula, R⁴⁰ represents a hydrogen atom or a methyl group.

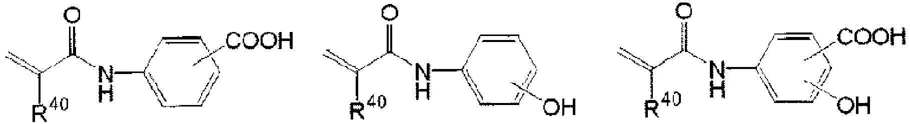

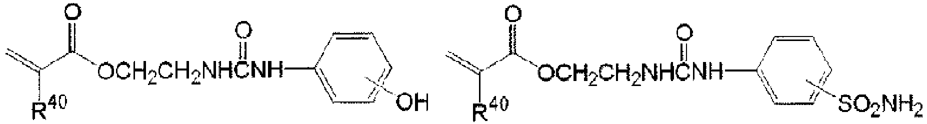

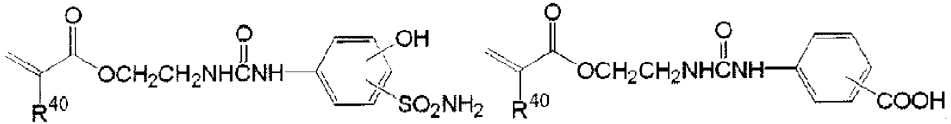

The water-insoluble and alkali-soluble resin which can be used in the present disclosure is preferably a polymer compound obtained by copolymerizing another polymerizable monomer in addition to the above-mentioned polymerizable monomers. As the copolymerization ratio in this case, a monomer imparting alkali-solubility such as a monomer having a functional group such as a phenolic hydroxyl group, a carboxyl group, a sulfonate group, a phosphate group, a sulfonamide group, or an active imide group is preferably included in 10 mol% or greater, and more preferably included in 20 mol% or greater. In a case where the copolymerization component of the monomer imparting alkali-solubility is 10 mol% or greater, sufficient alkali-solubility is obtained, and developability is excellent.

Examples of other usable polymerizable monomers include compounds exemplified below.

Alkyl acrylates or alkyl methacrylates such as methyl acrylate, ethyl acrylate, propyl acrylate, benzyl acrylate, methyl methacrylate, ethyl methacrylate, cyclohexyl methacrylate, and benzyl methacrylate. Acrylic acid esters or methacrylic acid esters having an aliphatic hydroxyl group such as 2-hydroxyethyl acrylate and 2-hydroxyethyl methacrylate. Acrylamides or methacrylamides such as acrylamide, methacrylamide, N-methylacrylamide, N-ethylacrylamide, and N-phenylacrylamide. Vinyl esters such as vinyl acetate, vinyl chloroacetate, vinyl butyrate, and vinyl benzoate. Styrenes such as styrene, α-methylstyrene, methylstyrene, and chloromethylstyrene. Other nitrogen atom-containing monomers such as N-vinyl pyrrolidone, N-vinyl pyridine, acrylonitrile, and methacrylonitrile. Maleimides such as N-methylmaleimide, N-ethylmaleimide, N-propylmaleimide, N-butylmaleimide, N-phenylmaleimide, N-2-methylphenylmaleimide, N-2,6-diethylphenylmaleimide, N-2-chlorophenylmaleimide, N-cyclohexylmaleimide, N-laurylmaleimide, and N-hydroxyphenylmaleimide.

Among these other ethylenically unsaturated monomers, (meth)acrylic acid esters, (meth)acrylamides, maleimides, or (meth)acrylonitrile is suitably used.

In addition, as the alkali-soluble resin, a novolac resin exemplified as another alkali-soluble resin described as an optional component of the positive type photosensitive resin composition according to the present disclosure may also be preferably exemplified.

In addition, the water-insoluble and alkali-soluble resin described above can also be used in the positive type photosensitive resin composition according to the present disclosure.

Furthermore, in the upper layer of the present disclosure, other resins can be used in combination within a range not impairing the effects according to the present disclosure. Since the upper layer is required to express alkali-solubility, in particular, in a non-image area region, it is necessary to select a resin which does not impair this characteristic. From this viewpoint, as a resin usable in combination, a water-insoluble and alkali-soluble resin is exemplified. General water-insoluble and alkali-soluble resin will be described below in detail, and among these, a polyamide resin, an epoxy resin, a polyacetal resin, an acrylic resin, a methacrylic resin, a polystyrene-based resin, and a novolac-type phenolic resin are preferably exemplified.

In addition, the amount to be mixed is preferably 50% by mass or less with respect to the water-insoluble and alkali-soluble resin.

The water-insoluble and alkali-soluble resin preferably has a weight-average molecular weight of 2,000 or greater and a number average molecular weight of 500 or greater, and more preferably has a weight-average molecular weight of 5,000 to 300,000 and a number average molecular weight of 800 to 250,000. The dispersity (weight-average molecular weight/number average molecular weight) of the alkali-soluble resin is preferably 1.1 to 10.

The water-insoluble and alkali-soluble resin used in the upper layer according to the present disclosure may be used alone or in combination of two or more types thereof.

The content of the alkali-soluble resin with respect to the total mass of the solid content in the upper layer according to the present disclosure is preferably 2.0% to 99.5% by mass, more preferably 10.0% to 99.0% by mass, and still more preferably 20.0% to 90.0% by mass, in the total solid content. In a case where the content of the alkali-soluble resin is 2.0% by mass or greater, the durability of the image recording layer (photosensitive layer) is excellent. Further, in a case where the content of the alkali-soluble resin is 99.5% by mass or less, both the sensitivity and the durability are excellent.

### [Infrared absorbent]

The upper layer may contain an infrared absorbent.

The infrared absorbent is not particularly limited as long as it is a dye which generates heat by absorbing infrared light, and the infrared absorbent used in the positive type photosensitive resin composition according to the present disclosure, described above, can also be used.

A particularly preferable dye is the cyanine dye represented by Formula (a).

In a case where the upper layer contains an infrared absorbent, a positive type planographic printing plate precursor having excellent image forming properties is obtained.

The content of the infrared absorbent in the upper layer is preferably 0.01% to 50% by mass, more preferably 0.1% to 30% by mass, and particularly preferably 1.0% to 10% by mass, with respect to the total mass of the solid content in the upper layer. In a case where the content thereof is 0.01% by mass or greater, the sensitivity is improved, and in a case where the content thereof is 50% by mass or less, the uniformity of the layer is excellent and the durability of the layer is excellent.

### [Other components]

In addition, the upper layer of the positive type planographic printing plate precursor having a two-layer structure may include an acid generator, an acid proliferative agent, a development accelerator, a surfactant, a print-out agent/colorant, a plasticizer, or a wax agent.

As these components, respective components used in the positive type photosensitive resin composition according to the present disclosure, described above, can also be used, and the preferable aspects thereof are the same as described above.

### <Underlayer>

It is preferable that the underlayer of the positive type planographic printing plate precursor having a two-layer structure in the present disclosure is a layer containing the positive type photosensitive resin composition according to the present disclosure.

Further, it is preferable that the underlayer of the positive type planographic printing plate precursor having a two-layer structure in the present disclosure is formed by applying the positive type photosensitive resin composition according to the present disclosure.

By using the positive type photosensitive resin composition according to the present disclosure for the underlayer, a printing plate with excellent image forming properties and printing durability can be obtained.

By using the positive type photosensitive resin composition according to the present disclosure for the underlayer, the printing durability is improved in a case where materials such as an ink and paper having particularly poor quality are used.

Though the detailed mechanism by which the effects as described above are obtained is unclear, it is assumed that for the printing durability in printing, the film hardness of the resin used in the underlayer is important, and thus, it is assumed that, since the interaction (hydrogen bonding or the like) between the binders is strong, by using the positive type photosensitive resin composition according to the present disclosure having a high film hardness in the underlayer, the printing durability is improved.

In a case where the positive type photosensitive resin composition according to the present disclosure is used in the upper layer, it is preferable that the underlayer is also formed of the positive type photosensitive resin composition according to the present disclosure, but the underlayer may be formed using a resin composition other than the positive type photosensitive resin composition according to the present disclosure. A preferable aspect of the underlayer in this case is the same as the preferable aspect of the upper layer described above.

### <Support>

The support used in the positive type planographic printing plate precursor according to the present disclosure is not particularly limited as long as it is a dimensionally stable plate-shaped material having necessary strength and durability, and examples thereof include paper, paper on which plastic (for example, polyethylene, polypropylene, and polystyrene) has been laminated, a metal plate (for example, aluminum, zinc, and copper), a plastic film (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, and polyvinyl acetal), and paper or a plastic film on which the above-described metals have been laminated or vapor-deposited.

Moreover, as the support in a case where the positive type photosensitive resin composition according to the present disclosure is applied to the positive type planographic printing plate precursor, a polyester film or an aluminum plate is preferable. Among these, the aluminum plate which has excellent dimensional stability and is relatively inexpensive is particularly preferable. A suitable aluminum plate is a pure aluminum plate or an alloy plate which has aluminum as the main component and includes a small amount of other elements, or may be a plastic film on which aluminum has been laminated or vapor-deposited. Examples of other elements included in the aluminum alloy include silicon, iron, manganese, copper, magnesium, chromium, zinc, bismuth, nickel, and titanium. The content of other elements in the alloy is preferably 10% by mass or less.

Although particularly suitable aluminum in the positive type planographic printing plate precursor according to the present disclosure is pure aluminum, it is difficult to produce completely pure aluminum on refining technique, and thus, other elements may be slightly contained.

The composition of the aluminum plate used in the present disclosure as described above is not particularly limited, and aluminum plates formed of known and used materials in the related art can be appropriately used. The thickness of the aluminum plate used in the present disclosure is preferably in a range of 0.1 to 0.6 mm, more preferably in a range of 0.15 to 0.4 mm, and particularly preferably in a range of 0.2 to 0.3 mm.

Such an aluminum plate may be subjected to a surface treatment such as a surface-roughening treatment and an anodization treatment, as necessary. As the surface treatment of the aluminum support, for example, a degreasing treatment with a surfactant, an organic solvent, or an alkaline aqueous solution, a roughening treatment of a surface, an anodization treatment, or the like, as described in detail in paragraphs 0167 to 0169 of JP2009-175195A, is suitably performed.

The aluminum surface on which an anodization treatment has been performed may be subjected to a hydrophilizing treatment, as necessary.

As the hydrophilizing treatment, the alkali metal silicate (for example, sodium silicate aqueous solution) method, the method of treating with potassium fluoride zirconate or polyvinylphosphonic acid, or the like, as disclosed in paragraph 0169 of 2009-175195, is used.

In addition, the supports described in JP2011-245844A can also be preferably used.

### <Undercoat layer>

In a case where the positive type photosensitive resin composition according to the present disclosure is applied to the positive type planographic printing plate precursor, an undercoat layer can be provided between the support and the image recording layer as necessary.

As the undercoat layer component, various organic compounds can be used, and preferable examples thereof include phosphonic acids having an amino group such as carboxymethylcellulose or dextrin, an organic phosphonic acid, an organic phosphorus acid, an organic phosphinic acid, amino acids, and hydrochloride of an amine having a hydroxy group. In addition, these undercoat layer components may be used alone or in a mixture of two or more types thereof. Details of the compound used in the undercoat layer and the method of forming the undercoat layer are described in paragraphs 0171 and 0172 of JP2009-175195A, and those described here are also applied to the present disclosure.

The coating amount of the undercoat layer is preferably in a range of 2 to 200 mg/m² and more preferably in a range of 5 to 100 mg/m². In a case where the coating amount is in the above-described range, sufficient printing durability is obtained.

### <Back coat layer>

A back coat layer is provided on the rear surface of the support of the positive type planographic printing plate precursor according to the present disclosure, as necessary. As the back coat layer, coating layers formed of an organic polymer compound described in JP1993-45885A (JP-H05-45885A) or a metal oxide obtained by hydrolyzing and polycondensing an organic or inorganic metal compound described in JP1994-35174A (JP-H06-35174A) are preferably used. Among these coating layers, alkoxy compounds of silicon such as Si(OCH₃)₄, Si(OC₂H₅)₄, Si(OC₃H₇)₄, and Si(OC₄H₉)₄ are easily available at low cost, and coating layers of metal oxides obtained from these have excellent developer resistance, and thus, these are particularly preferable.

### (Method of preparing planographic printing plate)

A method of preparing the planographic printing plate according to the present disclosure includes an exposure step of image-exposing the positive type planographic printing plate precursor according to the present disclosure; and a development step of performing development on the exposed positive type planographic printing plate precursor using an alkali aqueous solution having a pH of 8.5 to 13.5, in this order.

According to the method of preparing the planographic printing plate according to the present disclosure, a planographic printing plate having excellent chemical resistance and printing durability is obtained.

Hereinafter, each step of the method of preparing a planographic printing plate according to the present disclosure will be described in detail.

### <Exposure step>

The method of preparing the planographic printing plate according to the present disclosure includes an exposure step of image-exposing the positive type planographic printing plate precursor according to the present disclosure.

As a light source of active light used in image exposure of the positive type planographic printing plate precursor of the present disclosure, a light source having an emission wavelength in the near infrared region to the infrared region is preferable, and solid-state laser or semiconductor laser is more preferable. Among these, in the present invention, it is particularly preferable that image exposure is performed by solid-state laser or semiconductor laser emitting infrared rays having a wavelength of 750 to 1,400 nm.

The output of the laser is preferably 100 mW or greater, and to shorten the exposure time, a multibeam laser device is preferable used. In addition, the exposure time per pixel is preferably within 20 µ seconds.

Energy with which the positive type planographic printing plate precursor is irradiated is preferably in a range of 10 to 300 mJ/cm². In a case where the energy is in the above-described range, the laser ablation is suppressed, and thus, it is possible to prevent an image from being damaged.

In the exposure according to the present disclosure, it is possible to expose by overlapping a light beam of the light source. The overlapping means that the sub-scanning pitch width is smaller than the beam diameter. For example, in a case where the beam diameter is expressed by the half width (FWHM) of the beam intensity, the overlapping can be quantitatively expressed by FWHM/sub-scanning pitch width (overlap coefficient). In the present disclosure, this overlap coefficient is preferably 0.1 or greater.

The scanning method of the light source of an exposure apparatus which can be used in the present disclosure is not particularly limited, and a drum outer surface scanning method, a drum inner surface scanning method, a planar scanning method, or the like can be used. In addition, the channel of the light source may be a single channel or a multichannel, and in the case of drum outer surface scanning method, the multichannel is preferably used.

### <Development step>

The method of preparing the planographic printing plate according to the present disclosure includes a development step of performing development using an alkali aqueous solution with a pH of 8.5 to 13.5 (hereinafter, also referred to as a "developer").

The developer used in the development step is an aqueous solution having a pH of 8.5 to 13.5 and more preferably an alkali aqueous solution having a pH of 12 to 13.5. The surfactant contributes to improvement of the developability.

Further, it is preferable that the developer contains a surfactant and more preferable that the developer contains at least an anionic surfactant or a nonionic surfactant. A surfactant contributes to improvement of processability.

As the surfactant used in the developer, any of an anionic surfactant, a nonionic surfactant, a cationic surfactant, and an amphoteric surfactant can be used, and as described above, an anionic surfactant or a nonionic surfactant is preferable.

As the anionic surfactant, the nonionic surfactant, the cationic surfactant, and the amphoteric surfactant used in the developer of the present disclosure, the surfactants described in paragraphs 0128 to 0131 of JP2013-134341A can be used.

In addition, from the viewpoint of stable solubility or turbidity in water, a surfactant preferably has a hydrophile-lipophile balance (HLB) value of 6 or greater and more preferably has a HLB value of 8 or greater.

As the surfactant used in the developer, an anionic surfactant or a nonionic surfactant is preferable, and an anionic surfactant containing sulfonic acid or sulfonate or a nonionic surfactant having an aromatic ring and an ethylene oxide chain is particularly preferable.

The surfactant can be used alone or in combination of two or more types thereof.

The content of the surfactant in the developer is preferably in a range of 0.01% to 10% by mass, and more preferably in a range of 0.01% to 5% by mass.

In a case where as a buffer, carbonate ions and hydrogencarbonate ions are included to maintain the pH of the developer at 8.5 to 13.5, it is possible to suppress variations in pH even in a case where the developer is used for a long period of time, and it is possible to suppress developability deterioration and a development scum occurrence due to the variation in pH. To make carbonate ions and hydrogencarbonate ions present in the developer, carbonate and hydrogencarbonate may be added to the developer, or by adjusting the pH after carbonate or hydrogencarbonate is added, carbonate ions and hydrogencarbonate ions may be generated. Although carbonate and hydrogencarbonate are not particularly limited, an alkali metal salt is preferable. Examples of the alkali metal include lithium, sodium, and potassium, and sodium is particularly preferable. These may be used alone or in combination of two or more types thereof.

The total amount of carbonate and hydrogencarbonate is preferably in a range of 0.3% to 20% by mass, more preferably in a range of 0.5% to 10% by mass, and particularly preferably in a range of 1% to 5% by mass, with respect to the total mass of the developer. In a case where the total amount is 0.3% by mass or greater, developability and processing capability are not reduced, and in a case where the total amount is 20% by mass or less, a precipitate or a crystal is less likely to be produced and at the time of the waste liquid treatment of the developer, gelation during neutralization is less likely to occur, and thus, trouble does not occur in the waste liquid treatment.

In addition, for the purpose of finely adjusting the alkali concentration or assisting dissolution of the non-image area image recording layer, supplementarily, other alkali agents, for example, organic alkali agents may be used in combination. Examples of the organic alkali agent include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide. Other alkali agents are used alone or in combination of two or more types thereof.

In addition to the above materials, the developer may contain a wetting agent, a preservative, a chelate compound, an antifoaming agent, an organic acid, an organic solvent, an inorganic acid, an inorganic salt, or the like. In a case where a water-soluble polymer compound is added, the plate surface is likely to be sticky particularly when the developer was fatigued, and thus a water-soluble polymer compound is preferably not added.

As the wetting agent, the wetting agents described in paragraph 0141 of JP2013-134341A can be suitably used. The wetting agent may be used alone or in combination of two or more types thereof. The wetting agent is preferably used in an amount of 0.1% to 5% by mass with respect to the total mass of the developing agent.

As the preservative, the preservatives described in paragraph 0142 of JP2013-134341A can be suitably used. Two or more preservatives are preferably used in combination such that the preservatives have effect of sterilization of various molds. The content of the preservative is an amount in which the effect is stably exhibited on bacteria, fungi, yeast or the like, and although the addition amount varies depending on the type of bacteria, molds, or yeast, the addition amount is preferably in a range of 0.01% to 4% by mass with respect to the total mass of the developer.

As the chelate compound, the chelate compounds described in paragraph 0143 of JP2013-134341A can be suitably used. As the chelating agent, a chelating agent which is stably present in the developer composition and does not impair the printability is selected. The content thereof is suitably in a range of 0.001% to 1.0% by mass with respect to the total mass of the developer.

As the antifoaming agent, the antifoaming agents described in paragraph 0144 of JP2013-134341A can be suitably used. The content of the antifoaming agent is suitably in a range of 0.001% to 1.0% by mass with respect to the total mass of the developer.

As the organic acid, the antifoaming agents described in paragraph 0145 of JP2013-134341A can be suitably used. The content of the organic acid is preferably in a range of 0.01% to 0.5% by mass with respect to the total mass of the developer.

Examples of the organic solvent include aliphatic hydrocarbons (hexane, heptane, "Isopar E, H, G" (manufactured by Exxon Chemical Company), gasoline, kerosene, and the like), aromatic hydrocarbons (toluene, xylene, and the like), halogenated hydrocarbons (methylene dichloride, ethylene dichloride, trichlene, monochlorobenzene, and the like), and polar solvents.

Examples of the polar solvent include alcohols (methanol, ethanol, propanol, isopropanol, benzyl alcohol, ethylene glycol monomethyl ether, 2-ethoxyethanol, and the like), ketones (methyl ethyl ketone, cyclohexanone, and the like), esters (ethyl acetate, methyl lactate, propylene glycol monomethyl ether acetate, and the like), others (triethyl phosphate, tricresyl phosphate, N-phenylethanolamine, N-phenyldiethanolamine, and the like).

In addition, in a case where the organic solvent is insoluble in water, it is also possible to use by solubilizing the organic solvent in water using a surfactant or the like. In a case where the developer contains an organic solvent, from the viewpoint of safety and inflammability, the concentration of the solvent is preferably less than 40% by mass.

Examples of the inorganic acid and the inorganic salt include phosphoric acid, metaphosphoric acid, ammonium primary phosphate, ammonium secondary phosphate, sodium primary phosphate, sodium secondary phosphate, potassium primary phosphate, potassium secondary phosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate, and nickel sulfate. The content of the inorganic salt is preferably in a range of 0.01% to 0.5% by mass with respect to the total mass of the developer.

The temperature for the development is not particularly limited as long as the development can be performed at the temperature, and is preferably 60°C or lower and more preferably in a range of 15°C to 40°C. In the development treatment using an automatic developing device, the developer becomes fatigued according to the treatment amount, and thus the processing capability may be restored using a replenisher or a fresh developer. By automatically setting the reference electric conductivity that determines the timing for replenishing the development replenisher to an appropriate value in consideration of the ratio between the processing fatigue and the carbon dioxide gas fatigue using an automatic developing device as described in JP1997-96910A (JP-H09-96910A), the activity of the developer may be maintained in an excellent state for a long period of time.

As one example of the development or the treatment after the development, a method of performing alkali development, removing the alkali in a post-water washing step, performing a gum treatment in a gumming step, and drying in a drying step can be exemplified. In addition, as another example, a method of performing pre-water washing, developing, and gumming at the same time by using an aqueous solution containing carbonate ions, hydrogencarbonate ions, and a surfactant can be preferably exemplified. Thus, particularly, the pre-water washing step may not be performed, and only by using one solution, pre-water washing, developing, and gumming are performed in one bath, and then, a drying step may be preferably performed. After the development, it is preferable that drying is performed after the excess developer is removed using a squeeze roller or the like. In a case where an unnecessary image area is present in the obtained planographic printing plate, the unnecessary image area is removed. For removal, for example, a method of removing the unnecessary image area by coating the area with an erasing solution, allowing the area to stand for a predetermined time, and washing the area with water, as described in JP1990-13293B (JP-H02-13293B), is preferable, and a method of irradiating the unnecessary image area with active rays guided by optical fibers and performing development as described in JP1993-174842A (JP-H05-174842A) can also be used.

The development step can be suitably performed by an automatic treatment device equipped with a rubbing member. Examples of the automatic treatment device include an automatic treatment device which performs a rubbing treatment while transporting the positive type planographic printing plate precursor after image exposure, described in JP1990-220061A (JP-H02-220061A) and JP1985-59351A (JP-S60-59351A), and an automatic treatment device which performs a rubbing treatment on the positive type planographic printing plate precursor after image exposure, set on a cylinder while rotating the cylinder, described in US5148746A, US5568768A, and GB2297719B. Among these, as the rubbing member, an automatic treatment device using a rotating brush roll is particularly preferable.

The rotating brush roll used in the present disclosure can be suitably selected in consideration of the difficulty in flawing of the image area and the stiffness of the support of the positive type planographic printing plate precursor. As the rotating brush roll, a known rotating brush roll formed by implanting a brush material into a plastic or metal roll can be used. For example, the brush rolls described in JP1983-159533A (JP-S58-159533A) or JP1991-100554A (JP-H03-100554A) or a brush roll formed by closely and radially wrapping a metal or plastic grooved material into which a brush material has been implanted in a row on a plastic or metal roll which becomes a core, as described in JP1987-167253Y (JP-S62-167253Y), can be used.

As the brush material, plastic fibers (for example, polyester-based synthetic fibers such as polyethylene terephthalate and polybutylene terephthalate, polyamide-based synthetic fibers such as nylon 6.6 and nylon 6.10, polyacryl-based synthetic fibers such as polyacrylonitrile and polyalkyl (meth)acrylate, and polyolefin-based synthetic fibers such as polypropylene and polystyrene) can be used, and for example, a plastic fiber having a diameter of a fiber hair of 20 to 400 µm and a length of a hair of 5 to 30 mm can be suitably used.

The outer diameter of the rotating brush roll is preferably in a range of 30 to 200 mm, and the circumferential speed of the front end of the brush rubbing the plate surface is preferably in a range of 0.1 to 5 m/sec. A plurality of the rotating brush rolls is preferably used.

Although the rotation direction of the rotating brush roll may be the same direction or may be the reverse direction, with respect to the transporting direction of the positive type planographic printing plate precursor, in a case where two or more rotating brush rolls are used, it is preferable that at least one rotating brush roll rotates in the same direction and at least one rotating brush roll rotates in the reverse direction. Thus, removal of the image recording layer of the non-image area becomes more reliable. Furthermore, it is also effective to swing the rotating brush roller in the rotation axis direction of the brush roll.

After the development step, a continuous or discontinuous drying step is preferably performed. Drying is performed by hot air, infrared rays, or far infrared rays.

As an automatic treatment machine suitably used for the method of preparing the planographic printing plate according to the present disclosure, a device having a developing unit and a drying unit is used, and a planographic printing plate is obtained by performing development and gumming on the positive type planographic printing plate precursor in a developer tank and drying the positive type planographic printing plate precursor in the drying unit.

In addition, for the purpose of improving printing durability or the like, it is also possible to heat the printing plate after developing in very strong conditions. The heating temperature is preferably in a range of 200°C to 500°C. In a case where the temperature is low, sufficient image strengthening effects are not obtained, and in a case where the temperature is too high, there is a possibility that problems such as deterioration of the support or thermal decomposition of the image area occur.

The planographic printing plate obtained in this manner is mounted on an offset printing machine, and can be suitably used in printing a large number of sheets.

### Examples

Hereinafter, the present invention will be described in detail using examples, but the present invention is not limited thereto. Moreover, "part" and "%" in the following examples respectively represent "part(s) by mass" and "% by mass" unless otherwise specified.

Further, hereinafter, a "compound represented by Formula SA-1" is simply referred to as a "compound SA-1".

Hereinafter, compounds SA-1 to SA-33, compounds CA-1 to CA-12, compounds CH-1 to CH-11, compounds DO-1 to DO-18, and compounds PE-1 to PE-22 respectively indicate the compounds SA-1 to SA-33, the compounds CA-1 to CA-12, the compounds CH-1 to CH-11, the compounds DO-1 to DO-18, and the compounds PE-1 to PE-22 described in the specific examples above.

### (Synthesis example)

### <Synthesis of diol compound represented by Formula E-1 (sulfonamide group-containing diol, compound SA-31)>

30.0 g of xanthone (manufactured by Tokyo Chemical Industry Co., Ltd.) and 90.0 g of sulfolane (manufactured by Tokyo Chemical Industry Co., Ltd.) were weighed in a three-neck flask provided with a condenser and a stirrer, and then 42.6 g of sulfur trioxide (manufactured by Nippon Soda Co., Ltd.) was added dropwise thereto at room temperature. The resulting solution was heated to 120°C, stirred for 2 hour, and cooled to 80°C. 73.3 g of thionyl chloride (manufactured by Wako Pure Chemical Industries, Ltd.) was added dropwise to the reaction solution, and the reaction solution was stirred for 3 hours. This reaction solution was cooled to room temperature while being stirred, and crystallized in 1 L of ice-cold water, followed by stirring for 10 minutes. This was collected by filtration and washed with 1 L of ion exchange water. The resultant was dried in a vacuum at 40°C for 24 hours, thereby obtaining 50 g of a precursor S-1 (disulfonic acid chloride substance) as a target object. It was confirmed from the nuclear magnetic resonance (NMR) spectrum that the obtained product was the precursor (S-1). The precursor S-1 was analyzed using ¹NMR. The result thereof is shown below.
¹NMR data (deuterated dimethyl sulfoxide (deuterated DMSO), 400 MHz, internal standard: tetramethylsilane)
δ (ppm) = 7.62-7.65 (d, 2H), 8.02-8.05 (d, 2H), 8.40 (s, 2H)

19.66 g of the precursor (S-1) obtained in the above-described manner, 35.0 g of water, and 33.0 g of acetonitrile were weighed in a three-neck flask provided with a condenser and a stirrer, and 21.6 g of 2-(2-aminoethoxy) ethanol (manufactured by Tokyo Chemical Industry Co., Ltd.) was added dropwise thereto for 1 hour while being cooled to 10°C, heated to 45°C, and stirred for 1 hour. Next, 1.0 g of concentrated hydrochloric acid and 85.0 g of water were added thereto, and the solution was cooled to 10°C and then crystallized. This was collected by filtration and washed with 100 g of water and 30 g of acetonitrile to obtain crystals. The crystals were dried in a vacuum at 40°C for 24 hours, thereby obtaining 22.6 g of a target object (compound SA-31). It was confirmed from the NMR spectrum that the obtained product was the target object. The result thereof is shown below.
¹NMR data (deuterated dimethyl sulfoxide (deuterated DMSO), 400 MHz, internal standard: tetramethylsilane)
δ (ppm) = 2.98 (m, 4H), 3.31 (m, 4H), 3.39 (m, 4H), 3.40 (m, 4H), 4.49 (brs, 2H), 7.93 (d, 2H), 7.95 (brs, 2H), 8.25 (dd, 2H), 8.58 (d, 2H)

In the same manner as described above, the compounds SA-1 to SA-30 and the compounds SA-32 to SA-33 can be synthesized.

### <Synthesis of polyester (PE-7) containing sulfonamide group in main chain>

10.00 g of the compound SA-31, 3.55 g of triethylamine (manufactured by Wako Pure Chemical Industries, Ltd.), and 37.16 g of N,N-dimethylacetamide (manufactured by Kanto Chemical Co., Inc.) were weighed in a three-neck flask provided with a condenser and a stirrer, and the temperature of the reaction solution was set to room temperature to obtain a uniform solution. Next, a solution of 3.81 g of adipic acid dichloride (manufactured by Tokyo Chemical Industry Co., Ltd.) and 30.5 g of N,N-dimethylacetamide (manufactured by Kanto Chemical Co., Inc.) was added dropwise at room temperature for 15 minutes using a dropping funnel, the resulting solution was stirred at room temperature for 30 minutes for a reaction, and the reaction solution was heated to 90°C and stirred for 5 hours. Subsequently, the reaction solution was cooled to room temperature.

The reaction solution was poured into 1 L of pure water, and then the polymer was precipitated. The resultant was collected by filtration, washed, and dried, thereby obtaining 9.9 g of polyester (PE-7) containing a sulfonamide group with a weight-average molecular weight of 74,000 in the main chain.

It was confirmed that whether the obtained product was the target substance based on the NMR spectrum, the infrared spectroscopy (IR) spectrum, and GPC (in terms of polystyrene). Compounds PE-1 to PE-6 and compounds PE-8 to PE-22 can be synthesized in the same manner as described above.

Further, the structure of PE-7 is as shown below.

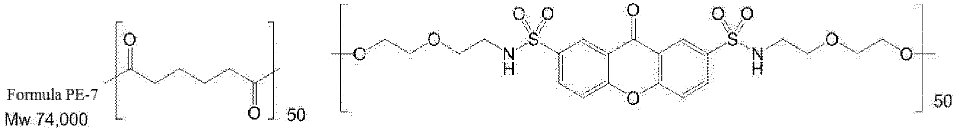

### (Examples 1 to 22 and Comparative Examples 1 and 2)

### <Preparation of support>

An aluminum alloy plate having a thickness of 0.3 mm of a material IS was subjected to the following (A-a) to (A-k) treatments, thereby producing a support for a planographic printing plate. Moreover, during all treatment steps, a washing treatment with water was performed, and after the washing treatment with water, liquid cutting was performed using a nip roller.

### (A-a) Mechanical roughening treatment (brush grain method)

While supplying a suspension of pumice (specific gravity of 1.1 g/cm³) to the surface of an aluminum plate as a polishing slurry liquid, a mechanical roughening treatment was performed using rotating bundle bristle brushes.

The median diameter (µm) of a polishing material was 30 µm, the number of the brushes was four, and the rotation speed (rpm) of the brushes was set to 250 rpm. The material of the bundle bristle brushes was nylon 6.10, the diameter of the brush bristles was 0.3 mm, and the bristle length was 50 mm. The brushes were produced by implanting bristles densely into the holes in a stainless steel cylinder having φ300 mm. The distance between two support rollers (φ200 mm) of the lower portion of the bundle bristle brush was 300 mm. The bundle bristle brushes were pressed until the load of a driving motor for rotating the brushes became 10 kW plus with respect to the load before the bundle bristle brushes were pressed against the aluminum plate. The rotation direction of the brushes was the same as the moving direction of the aluminum plate.

### (A-b) Alkali etching treatment

The aluminum plate obtained above was subjected to an etching treatment by spraying a caustic soda aqueous solution in which the concentration of caustic soda was 26% by mass and the concentration of aluminum ions was 6.5% by mass using a spray tube at a temperature of 70°C. Thereafter, washing with water by spraying was performed. The amount of aluminum dissolved was 10 g/m².

### (A-c) Desmutting treatment in acidic aqueous solution

Next, a desmutting treatment was performed in a nitric acid aqueous solution. As the nitric acid aqueous solution used in the desmutting treatment, the waste liquid of nitric acid used in electrochemical roughening of the next step was used. The liquid temperature was 35°C. The desmutting treatment was performed for 3 seconds by spraying the desmutting liquid using a spray.

### (A-d) Electrochemical roughening treatment

An electrochemical surface roughening treatment was continuously performed using an AC voltage of nitric acid electrolysis 60 Hz. As the electrolyte at this time, an electrolyte which had been adjusted to have a concentration of aluminum ions of 4.5 g/L by adding aluminum nitrate to a nitric acid aqueous solution having a concentration of 10.4 g/L at a temperature of 35°C was used. Using a trapezoidal rectangular waveform AC having a time tp until the current value reached a peak from zero of 0.8 msec and the duty ratio of 1:1 as the AC power supply waveform, the electrochemical surface-roughening treatment was performed using a carbon electrode as a counter electrode. As an auxiliary anode, ferrite was used. The current density was 30 A/dm² as the peak current value, and 5% of the current from the power source was separately flowed to the auxiliary anode. The electric quantity (C/dm²) was 185 C/dm² as the sum total of electric quantity at the time of anodization of the aluminum plate. Thereafter, washing with water by spraying was performed.

### (A-e) Alkali etching treatment

The aluminum plate obtained above was subjected to an etching treatment by spraying a caustic soda aqueous solution in which the concentration of caustic soda was 5% by mass and the concentration of aluminum ions was 0.5% by mass using a spray tube at a temperature of 50°C. Thereafter, washing with water by spraying was performed. The amount of aluminum dissolved was 0.5 g/m².

### (A-f) Desmutting treatment in acidic aqueous solution

Next, a desmutting treatment was performed in a sulfuric acid aqueous solution. As the sulfuric acid aqueous solution used in the desmutting treatment, a solution in which the concentration of sulfuric acid was 170 g/L and the concentration of aluminum ions was 5 g/L was used. The liquid temperature was 30°C. The desmutting treatment was performed for 3 seconds by spraying the desmutting liquid using a spray.

### (A-g) Electrochemical roughening treatment

An electrochemical surface roughening treatment was continuously performed using an AC voltage of hydrochloric acid electrolysis 60 Hz. As the electrolyte, an electrolyte which had been adjusted to have a concentration of aluminum ions of 4.5 g/L by adding aluminum nitrate to a hydrochloric acid aqueous solution having a concentration of 6.2 g/L at a liquid temperature of 35°C was used. Using a trapezoidal rectangular waveform AC having a time tp until the current value reached a peak from zero of 0.8 msec and the duty ratio of 1:1, the electrochemical surface-roughening treatment was performed using a carbon electrode as a counter electrode. As an auxiliary anode, ferrite was used.

The current density was 25 A/dm² as the peak current value, and the electric quantity (C/dm²) in the hydrochloric acid electrolysis was 63 C/dm² as the sum total of electric quantity at the time of anodization of the aluminum plate. Thereafter, washing with water by spraying was performed.

### (A-h) Alkali etching treatment

The aluminum plate obtained above was subjected to an etching treatment by spraying a caustic soda aqueous solution in which the concentration of caustic soda was 5% by mass and the concentration of aluminum ions was 0.5% by mass using a spray tube at a temperature of 50°C. Thereafter, washing with water by spraying was performed. The amount of aluminum dissolved was 0.1 g/m².

### (A-i) Desmutting treatment in acidic aqueous solution

Next, a desmutting treatment was performed in a sulfuric acid aqueous solution. Specifically, the desmutting treatment was performed at a liquid temperature of 35°C for 4 seconds using the waste liquid (aluminum ions having a concentration of 5 g/L were dissolved in a sulfuric acid aqueous solution having a concentration of 170 g/L) generated in the anodization treatment step. The desmutting treatment was performed for 3 seconds by spraying the desmutting liquid using a spray.

### (A-j) Anodization treatment

An anodization treatment was performed using an anodization apparatus (the length of each of a first electrolytic portion and a second electrolytic portion was 6 m, the length of each of a first feeding portion and a second feeding portion was 3 m, and the length of each of a first feeding electrode and a second feeding electrode was 2.4 m) of a two-stage feeding electrolytic treatment method. As the electrolyte supplied to the first electrolytic portion and the second electrolytic portion, sulfuric acid was used. All electrolytes have a concentration of sulfuric acid of 50 g/L (including 0.5% by mass of aluminum ions) and were at a temperature of 20°C. Thereafter, washing with water by spraying was performed.

### (A-k) Silicate treatment

To ensure hydrophilicity of the non-image area, a silicate treatment was performed by dipping at 50°C for 7 seconds using 2.5% by mass No. 3 sodium silicate aqueous solution. The amount of Si attached was 10 mg/m². Thereafter, washing with water by spraying was performed.

### <Formation of undercoat layer>

The support prepared in the above-described manner was coated with an undercoat layer coating solution 1 shown below, and the coating solution was dried at 80°C for 15 seconds, thereby preparing a support A provided with an undercoat layer. The coating amount after drying was 15 mg/m².

### (Undercoat layer coating solution 1)

- Following copolymer having a weight-average molecular weight of 28,000: 0.3 parts
- Methanol: 100 parts
- Water: 1 part

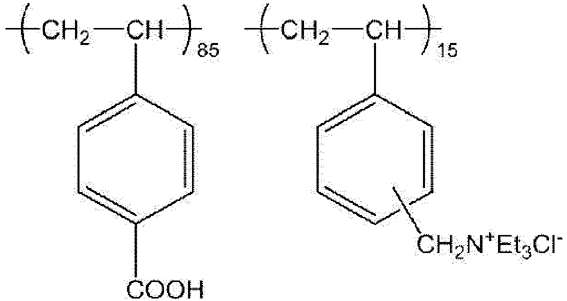

### <Formation of image recording layer>

After a coating solution composition (I) for forming an underlayer having the following compositional ratio was applied to the obtained support A using a wire bar, the resulting product was dried in a drying oven at 150°C for 40 seconds such that the coating amount became 1.0 g/m², whereby an underlayer was provided. After the underlayer was provided, a coating solution composition (II) for forming an upper layer having the following compositional ratio was applied using a wire bar, whereby an upper layer was provided. After application, the resulting product was dried at 150°C for 40 seconds, whereby a positive type planographic printing plate precursor in which the coating amount of the underlayer and the upper layer was 1.2 g/m² was obtained.

### [Coating solution composition (I) for forming underlayer]

- Polyester containing sulfonamide group in main chain listed in Table 2 : 3.5 parts
- m,p-Cresol novolac (m/p ratio = 6/4, weight-average molecular weight of 6,000): 0.6 parts
- Infrared absorbent (IR coloring agent (1): following structure): 0.2 parts
- 4,4'-Bishydroxyphenyl sulfone: 0.3 parts
- Tetrahydrophthalic acid: 0.4 parts
- p-Toluenesulfonic acid: 0.02 parts
- 3-Methoxy-4-diazodiphenylamine hexafluorophosphate: 0.06 parts
- Product obtained by replacing a counter ion of ethyl violet with 6-hydroxynaphthalenesulfonic acid: 0.15 parts
- Fluorine-based surfactant (MEGAFAC F-780, manufactured by DIC Corporation): 0.07 parts
- Methyl ethyl ketone: 30 parts
- 1-Methoxy-2-butyrolactone: 15 parts
- γ-Butyrolactone: 15 parts

### IR dye (1)

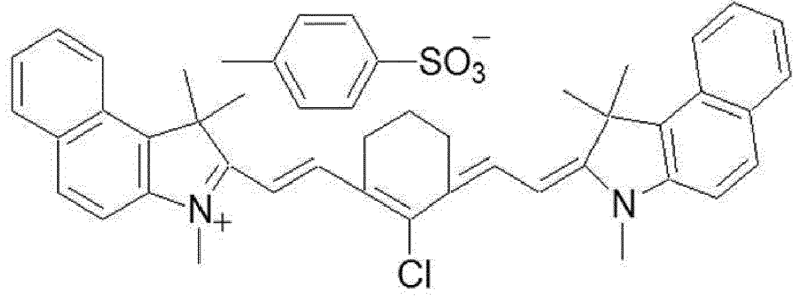

### [Coating solution composition (II) for forming upper layer]

- Novolac resin (m-cresol/p-cresol/phenol = 3/2/5, Mw of 8,000): 0.68 parts
- Infrared absorbent (IR coloring agent (1): above structure): 0.045 parts
- Fluorine-based surfactant (MEGAFAC F-780, manufactured by DIC Corporation): 0.03 parts
- Methyl ethyl ketone: 15.0 parts
- 1-Methoxy-2-propanol: 30.0 parts
- 5-Benzoyl-4-hydroxy-2-methoxybenzenesulfonate of 1-(4-methylbenzyl)-1-phenylpiperidinium : 0.01 parts

The following evaluations were performed on the obtained positive type planographic printing plate precursors, and the results are shown in the following Table 2.

### <Evaluation of non-image area development time>

Drawing of a test pattern in an image shape was performed on each positive type planographic printing plate precursor of each example and each comparative example using a Trendsetter VX manufactured by Creo Company while changing the exposure energy. Thereafter, the resulting product was immersed in a developing bath charged with a developer XP-D (which was made to have a conductivity of 43 mS/cm by diluting) manufactured by Fujifilm Corporation, and the time required for developing the non-image area at a developing temperature of 30°C was measured. The immersion time at which the image density in a non-image area became equal to the image density of the aluminum support was set as a non-image area development time. The image density of the non-image area and the image density of the aluminum support were measured using a reflection densitometer RD-19 (manufactured by GretagMacbeth Company). As the non-image area development time is shorter, the solubility of a non-image area in an alkali aqueous solution is excellent and an alkali aqueous solution developability (highlight reproducibility) is good. The results are shown in Table 2.

### <Evaluation of printing durability>

Drawing of a test pattern in an image shape was performed on each positive type planographic printing plate precursor of each example and each comparative example using a Trendsetter manufactured by Creo Company at a beam intensity of 9 W and a drum rotation speed of 150 rpm. Thereafter, in the examples, using PS PROCESSOR LP940H manufactured by Fujifilm Corporation charged with a developer XP-D (which was made to have a conductivity of 43 mS/cm by diluting) manufactured by Fujifilm Corporation, development was performed at a developing temperature of 30°C and a development time of 12 seconds. In Comparative Example 1, the development was performed for a development time of 150 seconds under the same conditions as described above. In Comparative Example 2, the development was performed for 25 seconds under the same conditions. This was continuously printed using a printer LITHRONE manufactured by KOMORI Corporation. As the ink, a tokunen black ink manufactured by TOYO INK CO., LTD. which contains calcium carbonate, as a model of low-grade material was used. At this time, by visually observing how much sheets could be printed while maintaining a sufficient ink density, the printing durability was evaluated. As the number of sheets was larger, the printing durability was evaluated to be excellent. The results are shown in Table 2.

### <Evaluation of chemical resistance>

Exposure, development, and printing were performed on each positive type planographic printing plate precursor of each example and each comparative example in the same manner as in the evaluation of the printing durability. In this time, every time 5,000 sheets were printed, a step of wiping the plate surface with a cleaner (manufactured by Fujifilm Corporation, multi cleaner) was performed, and the chemical resistance was evaluated. The printing durability at this time was evaluated as 1 in a case where the number of printed sheets was 95% to 100% of the number of printing endurable sheets described above, evaluated as 2 in a case where the number of printed sheets was 80% or greater and less than 95%, evaluated as 3 in a case where the number of printed sheets was 60% or greater and less than 80%, and evaluated as 4 in a case where the number of printed sheets was less than 60%. Even in a case where the step of wiping the plate surface with a cleaner was performed, as the change in the printing durability index was smaller, the chemical resistance was evaluated to be excellent. The results are shown in the following Table 2.

**[Table 2]**

| | Polyester containing sulfonamide group in main chain | Evaluation results | | |
|---|---|---|---|---|
| | | Non-image area development time (sec) | Printing durability number of printed sheets (10000 sheets) | Chemical resistance |
| Example 1 | PE-1 | 7 | 11 | 1 |
| Example 2 | PE-2 | 8 | 11 | 1 |
| Example 3 | PE-3 | 8 | 11 | 1 |
| Example 4 | PE-4 | 8 | 11 | 2 |
| Example 5 | PE-5 | 8 | 13 | 1 |
| Example 6 | PE-6 | 8 | 13 | 1 |
| Example 7 | PE-7 | 7 | 12 | 2 |
| Example 8 | PE-8 | 8 | 13 | 1 |
| Example 9 | PE-9 | 7 | 13 | 1 |
| Example 10 | PE-10 | 9 | 13 | 1 |
| Example 11 | PE-11 | 8 | 13 | 1 |
| Example 12 | PE-12 | 7 | 12 | 1 |
| Example 13 | PE-13 | 8 | 13 | 1 |
| Example 14 | PE-14 | 8 | 14 | 1 |
| Example 15 | PE-15 | 7 | 12 | 2 |
| Example 16 | PE-16 | 8 | 13 | 1 |
| Example 17 | PE-17 | 8 | 13 | 1 |
| Example 18 | PE-18 | 8 | 12 | 1 |
| Example 19 | PE-19 | 8 | 12 | 1 |
| Example 20 | PE-20 | 7 | 12 | 2 |
| Example 21 | PE-21 | 8 | 14 | 1 |
| Example 22 | PE-22 | 8 | 13 | 1 |
| Comparative example 1 | R-1 | 150 | 6 | 4 |
| Comparative example 2 | R-2 | 25 | 7 | 4 |

### <Synthesis example of polyester (R-1) used in Comparative Example 1>

13.82 g of 1,4-benzenedimethanol (manufactured by Tokyo Chemical Industry Co., Ltd.), 10.1 g of triethylamine (manufactured by Wako Pure Chemical Industries, Ltd.), and 41.4 g of N,N-dimethylacetamide (manufactured by Kanto Chemical Co., Inc.) were weighed in a three-neck flask provided with a condenser and a stirrer, and a uniform solution was obtained. Next, a solution of 14.61 g of adipic acid dichloride (manufactured by Tokyo Chemical Industry Co., Ltd.) and 30.5 g of N,N-dimethylacetamide (manufactured by Kanto Chemical Co., Inc.) was added dropwise at room temperature for 1 hour using a dropping funnel. Thereafter, the reaction solution was heated to 90°C to cause a reaction for 5 hours. The reaction solution was cooled at room temperature and added dropwise to 2 L of pure water, and then the polymer was precipitated. The resultant was collected by filtration, washed, and dried, whereby 12.5 g of polyester (R-1) with a weight-average molecular weight of 76000 was obtained. It was confirmed from the NMR spectrum, the IR spectrum, and GPC (in terms of polystyrene) that the obtained product was the target substance.

### <Synthesis example of polyester (R-2) used in Comparative Example 2]

13.4 g of 2,2-bis(hydroxyethyl)propionic acid (manufactured by Tokyo Chemical Industry Co., Ltd.), 17.2 g of 4-aminobenzenesulfonamide (manufactured by Tokyo Chemical Industry Co., Ltd.), 0.86 g of p-toluenesulfonic acid (manufactured by Tokyo Chemical Industry Co., Ltd.), and 153.0 g of N-methylpyrrolidone (manufactured by Kanto Chemical Co., Inc.) were weighed in a three-neck flask provided with a condenser and a stirrer, and the solution was heated to 70°C to cause a reaction for 14 hours. The reaction solution was cooled at room temperature and added dropwise to 1 L of pure water, and then the polymer was precipitated. The resultant was collected by filtration, washed, and dried, thereby obtaining 26.3 g of an intermediate 3-hydroxy-2-(hydroxymethyl)-2-methyl-N-(4-sulfamoylphenyl)propanamide (RI-1). It was confirmed from the NMR spectrum that the obtained product was the target substance.

Next, 14.4 g of RI-1, 43.2 g of N,N-dimethylacetamide (manufactured by Kanto Chemical Co., Inc.), and 5.1 g of triethylamine (manufactured by Wako Pure Chemical Industries, Ltd.) were weighed in a three-neck flask provided with a condenser and a stirrer, and a uniform solution was obtained. Next, a solution obtained by dissolving 10.2 g of isophthalic acid dichloride (manufactured by Tokyo Chemical Industry Co., Ltd.) and 50.6 g of N,N-dimethylacetamide (manufactured by Kanto Chemical Co., Inc.) was added dropwise to the reaction solution at room temperature for 1 hour using a dropping funnel. Thereafter, the reaction solution was heated to 90°C to cause a reaction for 5 hours. The reaction solution was cooled at room temperature and added dropwise to 2 L of pure water, and then the polymer was precipitated. The resultant was collected by filtration, washed, and dried, whereby 14.5 g of polyester (R-2) with a weight-average molecular weight of 76000 was obtained. It was confirmed from the NMR spectrum, the IR spectrum, and GPC (in terms of polystyrene) that the obtained product was the target substance.

The structures of the obtained compounds R-1 and R-2 are shown below. In Formulae R-1 to R-2, the numerical values on the lower right side of [ ] respectively represent a containing molar ratio of each constitutional unit. Further, in Formulae R-1 and R-2, description on carbon atoms and hydrogen atoms contained in hydrocarbons will not be provided.

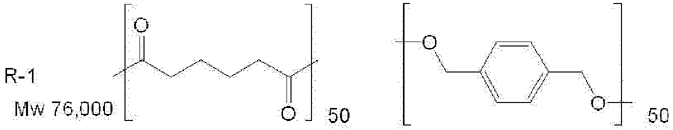

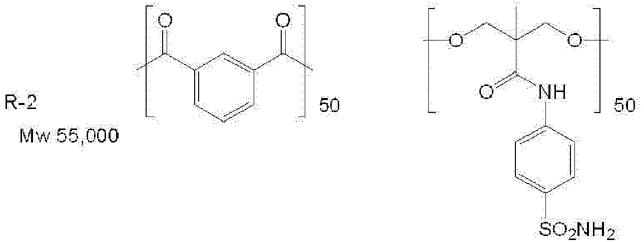

As evident from the results listed in Table 2, it was understood that the solubility of a non-image area in a positive type planographic printing plate precursor to be obtained in an alkali aqueous solution was excellent and the chemical resistance and the printing durability of a planographic printing plate to be obtained were excellent in a case where the positive type photosensitive resin composition according to the present disclosure was used.

### (Examples 23 to 44 and Comparative Examples 3 and 4)

### <Preparation of support>

In the same manner as in Example 1, each support for a planographic printing plate was produced.

### <Formation of undercoat layer>

In the same manner as in Example 1, each support A having an undercoat layer was prepared.

### <Formation of image recording layer>

After each of the obtained supports A was coated with a coating solution composition (III) for forming an image recording layer having the following composition using a wire bar, the resulting product was dried in a drying oven at 140°C for 50 seconds, thereby obtaining a planographic printing plate precursor having a coating amount of 1.2 g/m².

### [Coating solution composition (III) for forming image recording layer]

- m,p-Cresol novolac (m/p ratio = 6/4, weight-average molecular weight of 6,000): 0.474 parts
- Polyester containing sulfonamide group in main chain listed in Table 3: 2.37 parts
- Infrared absorbent (above IR coloring agent (1)): 0.155 parts
- 2-Methoxy-4-(N-phenylamino)benzenediazonium hexafluorophosphate: 0.03 parts
- Tetrahydrophthalic anhydride: 0.19 parts
- Product obtained by replacing a counter ion of ethyl violet with 6-hydroxy-β-naphthalenesulfonic acid: 0.11 parts
- Fluorine-based surfactant (MEGAFAC F-780, manufactured by Dainippon Ink and Chemicals): 0.07 parts
- p-Toluenesulfonic acid: 0.008 parts
- Bis-p-hydroxyphenyl sulfone: 0.13 parts
- 3,3'-Dimyristyl thiodipropionate : 0.04 parts
- Lauryl stearate: 0.02 parts
- N,N-dimethylacetamide: 13 parts
- Methyl ethyl ketone: 24 parts
- 1-Methoxy-2-propanol: 11 parts
- γ-Butyrolactone: 15 parts

The evaluation of the non-image area development time, the evaluation of the printing durability, and the evaluation of the chemical resistance were performed in the same manner as in Example 1 using each of the obtained planographic printing plate precursors in each example and each comparative example. Further, in the evaluation of the printing durability, the development time in Examples 23 to 44 was set to 12 seconds, the development time in Comparative Example 3 was set to 130 seconds, and the development time in Comparative Example 4 was set as 25 seconds. The evaluation results are listed in Table 3.

**[Table 3]**

| | Polyester containing sulfonamide group in main chain | Evaluation results | | |
|---|---|---|---|---|
| | | Non-image area development time (sec) | Printing durability number of printed sheets (10000 sheets) | Chemical resistance |
| Example 23 | PE-1 | 7 | 10 | 1 |
| Example 24 | PE-2 | 7 | 10 | 1 |
| Example 25 | PE-3 | 8 | 10 | 1 |
| Example 26 | PE-4 | 8 | 10 | 2 |
| Example 27 | PE-5 | 8 | 12 | 1 |
| Example 28 | PE-6 | 7 | 12 | 1 |
| Example 29 | PE-7 | 7 | 11 | 2 |
| Example 30 | PE-8 | 8 | 12 | 1 |
| Example 31 | PE-9 | 7 | 12 | 1 |
| Example 32 | PE-10 | 8 | 12 | 1 |
| Example 33 | PE-11 | 7 | 12 | 1 |
| Example 34 | PE-12 | 7 | 11 | 1 |
| Example 35 | PE-13 | 7 | 12 | 1 |
| Example 36 | PE-14 | 7 | 13 | 1 |
| Example 37 | PE-15 | 7 | 11 | 2 |
| Example 38 | PE-16 | 8 | 13 | 1 |
| Example 39 | PE-17 | 8 | 12 | 1 |
| Example 40 | PE-18 | 8 | 11 | 1 |
| Example 41 | PE-19 | 7 | 11 | 1 |
| Example 42 | PE-20 | 7 | 11 | 2 |
| Example 43 | PE-21 | 8 | 13 | 1 |
| Example 44 | PE-22 | 8 | 12 | 1 |
| Comparative example 3 | R-1 | 130 | 5 | 4 |
| Comparative example 4 | R-2 | 25 | 6 | 4 |

As evident from the results listed in Table 3, it was understood that the solubility of a non-image area in a positive type planographic printing plate precursor to be obtained in an alkali aqueous solution was excellent and the chemical resistance and the printing durability of a planographic printing plate to be obtained were excellent in a case where the positive type photosensitive resin composition according to the present disclosure was used.

## Claims

1. A positive type photosensitive resin composition, comprising:
a polyester comprising a sulfonamide group in a main chain thereof; and
an infrared absorbent.

2. The positive type photosensitive resin composition according to claim 1, wherein the polyester comprises a constitutional unit represented by the following Formula A-1: 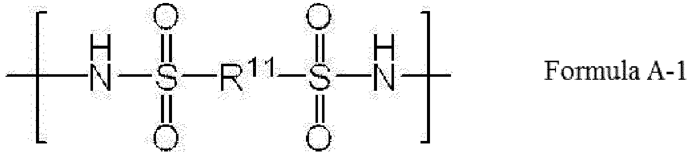 wherein, in Formula A-1, R¹¹ represents a divalent linking group.

3. The positive type photosensitive resin composition according to claim 1 or 2, wherein the polyester further comprises a polycyclic structure in the main chain thereof.

4. The positive type photosensitive resin composition according to claim 2, wherein the constitutional unit represented by Formula A-1 comprises at least one constitutional unit selected from the group consisting of constitutional units represented by the following Formulae B-1 to B-6: 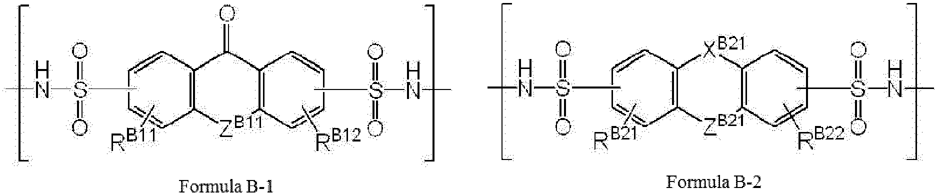 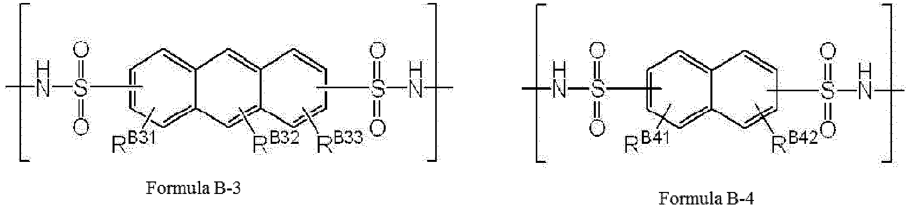 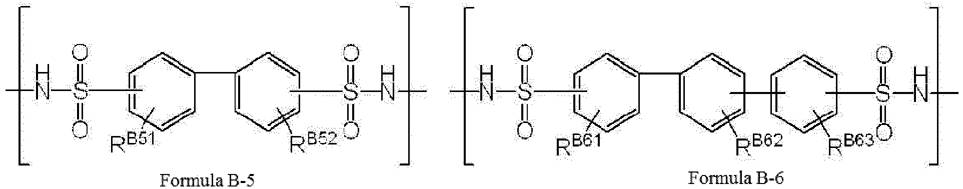
wherein, in Formulae B-1 to B-6, R^{B11}, R^{B12}, R^{B21}, R^{B22}, R^{B31} to R^{B33}, R^{B41}, R^{B42}, R^{B51}, R^{B52}, and R^{B61} to R^{B63} each independently represent a hydrogen atom, a sulfonamide group, a hydroxyl group, a carboxyl group, an alkyl group, or a halogen atom;
Z^{B11} represents -C(R)₂-, -C(=O)-, -O-, -NR-, -S-, or a single bond, wherein R represents a hydrogen atom or an alkyl group;
Z^{B21} represents -C(R)₂-, -O-, -NR-, -S-, or a single bond, wherein R represents a hydrogen atom or an alkyl group; and
X^{B21} represents -C(R')₂-, -O-, -NR'-, -S-, or a single bond, wherein R' represents a hydrogen atom or an alkyl group.

5. The positive type photosensitive resin composition according to claim 1, wherein the polyester comprises a constitutional unit represented by the following Formula A-2: 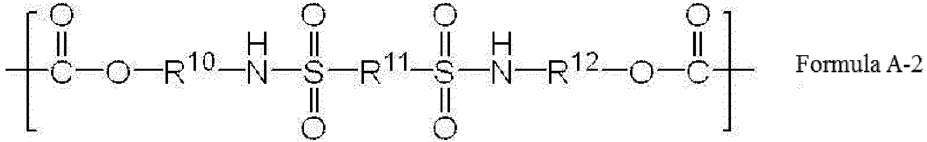 wherein, in Formula A-2, R¹⁰ to R¹² represent a divalent linking group.

6. The positive type photosensitive resin composition according to claim 5, wherein the constitutional unit represented by Formula A-2 comprises at least one constitutional unit selected from the group consisting of constitutional units represented by the following Formulae C-1 to C-6: 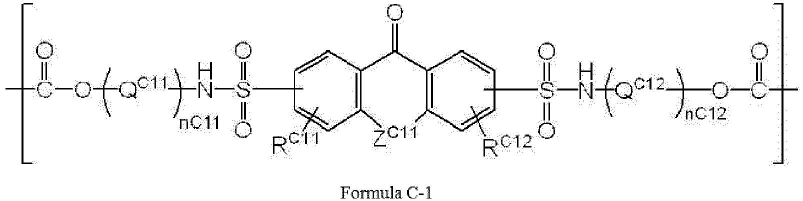 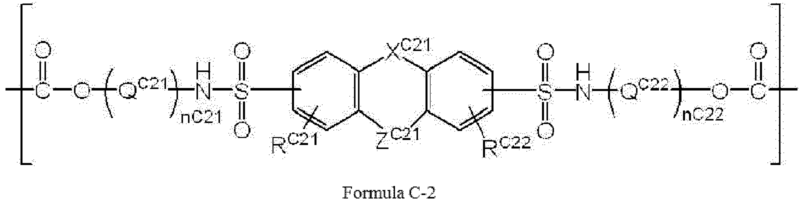 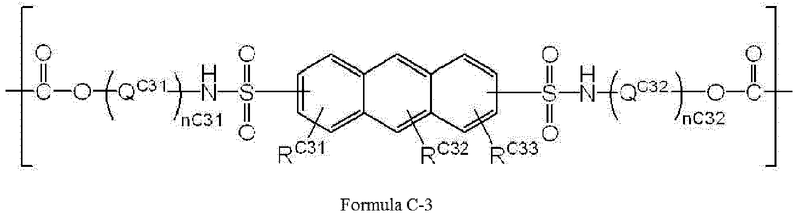 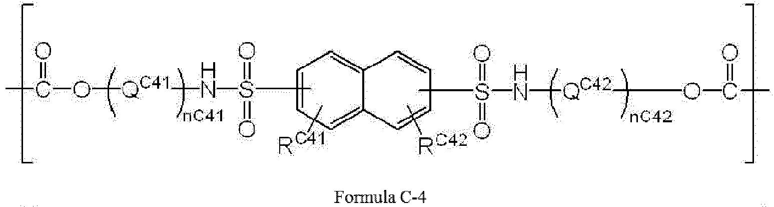 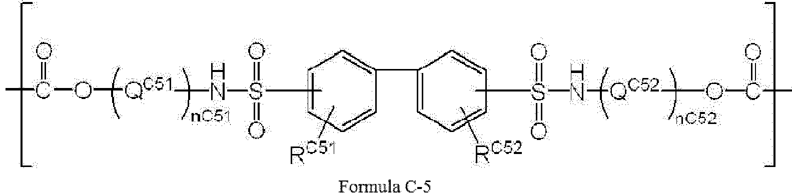 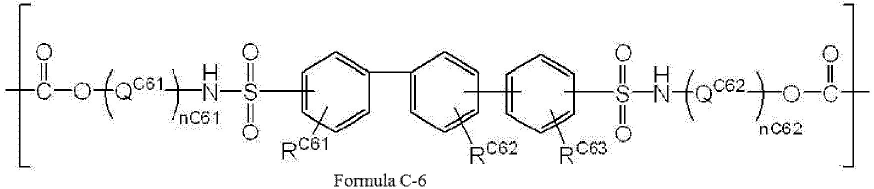
wherein, in Formulae C-1 to C-6, R^{C11}, R^{C12}, R^{C21}, R^{C22}, R^{C31} to R^{C33}, R^{C41}, R^{C42}, R^{C51}, R^{C52}, and R^{C61} to R^{C63} each independently represent a hydrogen atom, a sulfonamide group, a hydroxyl group, a carboxyl group, an alkyl group, or a halogen atom;
Z^{C11} and Z^{C21} each independently represent -C(R)₂-, -O-, -NR-, -S-, or a single bond, wherein R represents a hydrogen atom or an alkyl group;
X^{C21} represents -C(R')₂-, -O-, -NR'-, -S-, or a single bond, wherein R' represents a hydrogen atom or an alkyl group;
Q^{C11}, Q^{C12}, Q^{C21}, Q^{C22}, Q^{C31}, Q^{C32}, Q^{C41}, Q^{C42}, Q^{C51}, Q^{C52}, Q^{C61}, and Q^{C62} each independently represent an alkylene group, an arylene group, a divalent saturated alicyclic hydrocarbon group, a divalent unsaturated alicyclic hydrocarbon group, or a divalent group formed by a plurality of these groups being linked to one another; and
nC11, nC12, nC21, nC22, nC31, nC32, nC41, nC42, nC51, nC52, nC61, and nC62 each independently represent an integer of 1 or larger.

7. The positive type photosensitive resin composition according to claim 6, wherein the constitutional unit represented by Formula A-2 comprises the constitutional unit represented by Formulae C-1 or C-2.

8. A positive type planographic printing plate precursor, comprising:
a support comprising a hydrophilic surface; and
an image recording layer comprising the positive type photosensitive resin composition according to any one of claims 1 to 7, on the support.

9. The positive type planographic printing plate precursor according to claim 8, wherein:
the image recording layer comprising an underlayer and an upper layer in this order is formed on the support having the hydrophilic surface; and
at least one of the underlayer and the upper layer comprises the positive type photosensitive resin composition.

10. The positive type planographic printing plate precursor according to claim 8 or 9, further comprising:
an undercoat layer between the support having the hydrophilic surface and the image recording layer.

11. A method of producing a planographic printing plate, comprising, in the following order:
an exposure step of subjecting the positive type planographic printing plate precursor according to any one of claims 8 to 10 to image-wise light exposure; and
a development step of subjecting the positive type planographic printing plate precursor after the light exposure to development using an alkali aqueous solution having a pH of from 8.5 to 13.5.
